# EUROPEAN PATENT APPLICATION

(11) **EP 4 852 354 A1**
(43) Date of publication of application: **09.12.2026**
(21) Application number: 24923392.5
(22) Date of filing: 21.10.2024
(51) Int. Cl.: H04L 1/00, H03M 13/11

(54) **DATA TRANSMISSION METHOD, AND DEVICE AND STORAGE MEDIUM**

(30) Priority: 05.02.2024 CN 202410165502
(71) Applicant: ZTE Corporation, Shenzhen, Guangdong 518057 (CN)
(72) Inventor: LI, Liguang, Shenzhen, Guangdong 518057 (CN); XU, Jin, Shenzhen, Guangdong 518057 (CN); LIANG, Chulong, Shenzhen, Guangdong 518057 (CN); ZHAO, Wei, Shenzhen, Guangdong 518057 (CN); YU, Guanghui, Shenzhen, Guangdong 518057 (CN); FU, Qiang, Shenzhen, Guangdong 518057 (CN); KANG, Jian, Shenzhen, Guangdong 518057 (CN)
(74) Representative: Aipex B.V.
(86) International application number: PCT/CN2024/125989
(87) International publication number: WO 2025/167188

(57) **Abstract**

Provided are a data transmission method, a device, and a storage medium. A data transmission method applied to a first communication device includes determining a to-be-encoded bit sequence (S110); performing cyclic redundancy check, CRC, encoding on the to-be-encoded bit sequence to obtain at least one CRC-coded sequence (S120); performing spatially coupled low-density parity-check, LDPC, encoding on the at least one CRC-coded sequence to obtain a coded bit sequence, where the at least one CRC-coded sequence includes at least two sub-codeblock information sequences used in the spatially coupled LDPC coding (S130); and transmitting at least a portion of bits in the coded bit sequence (S140).

## Description

### TECHNICAL FIELD

The present application relates to the field of communication technology, and in particular, to a data transmission method, a device, and a storage medium.

### BACKGROUND

With the rapid development of technologies such as big data, cloud computing, and time-sensitive networks, the number of user equipments in wireless communication networks has experienced explosive growth. Wireless communication networks will carry diverse applications and massive data, which impose high requirements on data transmission throughput, reliability, and latency. With the development of fields such as intelligent transportation, intelligent industrial control, and intelligent logistics, there is an increasing demand for ultra-low latency and ultra-high reliability communication. That is, it is necessary to send and successfully receive some high-throughput data in an extremely short time. However, ultra-high throughput data transmission rates result in very high complexity of channel coding and large power consumption for decoding. Thus, it is necessary to further improve coding schemes under ultra-high throughput decoding.

### SUMMARY

In view of the above, embodiments of the present application provide a data transmission method, a device, and a storage medium, which reduce reception latency and decoding performance loss while increasing the robustness of data communication.

Embodiments of the present application provide a data transmission method applied to a first communication device.

The method includes determining a to-be-encoded bit sequence; performing cyclic redundancy check (CRC) encoding on the to-be-encoded bit sequence to obtain at least one CRC-coded sequence; performing spatially coupled low-density parity-check (LDPC) encoding on the at least one CRC-coded sequence to obtain a coded bit sequence, where the at least one CRC-coded sequence includes at least two sub-codeblock information sequences used in the spatially coupled LDPC coding; and transmitting at least a portion of bits in the coded bit sequence.

Embodiments of the present application provide a data transmission method applied to a second communication device.

The method includes acquiring to-be-decoded data; performing spatially coupled LDPC decoding on the to-be-decoded data to obtain at least one first decoded sequence, where the at least one first decoded sequence corresponds to at least one CRC-coded sequence, and the at least one CRC-coded sequence includes at least two sub-codeblock information sequences used in spatially coupled LDPC coding; and obtaining a corresponding to-be-encoded bit sequence from the first decoded sequence.

Embodiments of the present application provide a communication device. The communication device includes a memory and one or more processors. The memory is configured to store one or more programs. The one or more programs, when executed by the one or more processors, cause the one or more processors to implement the data transmission method according to any of the preceding embodiments.

Embodiments of the present application provide a storage medium. The storage medium stores a computer program, and when the computer program is executed by a processor, the data transmission method according to any of the preceding embodiments is implemented.

### BRIEF DESCRIPTION OF DRAWINGS

FIG. 1 is a flowchart of a data transmission method according to an embodiment of the present application.
FIG. 2 is a flowchart of another data transmission method according to an embodiment of the present application.
FIG. 3 is a flowchart of another data transmission method according to embodiments of the present application.
FIG. 4 is a diagram illustrating the configuration of a base matrix and a base graph matrix for spatially coupled LDPC coding according to an embodiment of the present application.
FIG. 5 is a diagram illustrating the configuration of a coded bit sequence according to an embodiment of the present application.
FIG. 6 is a flowchart of another data transmission method according to embodiments of the present application.
FIG. 7 is a diagram illustrating an implementation of decoding according to an embodiment of the present application.
FIG. 8 is a block diagram illustrating the structure of a data transmission apparatus according to an embodiment of the present application.
FIG. 9 is a block diagram illustrating the structure of another data transmission apparatus according to an embodiment of the present application.
FIG. 10 is a diagram illustrating the structure of a communication device according to an embodiment of the present application.

### DETAILED DESCRIPTION

Embodiments of the present application are described below in conjunction with drawings. The present application is described below in conjunction with the drawings of the embodiments. The examples given are only used to explain the present application and are not intended to limit the scope of the present application.

In a wireless communication system, a transmitting end performs channel encoding on to-be-transmitted data to obtain an encoded bit sub-sequence, and then maps the encoded bit subsequence into constellation modulation symbols to be transmitted to a receiving end. In a data transmission channel, errors occur in data transmission due to influences such as multipath, noise, and interference. The transmitting end adds redundancy information to the to-be-transmitted data through channel coding. The receiving end may recover original to-be-transmitted data by using the redundancy information, thereby eliminating distortion caused during data transmission. The receiving end needs to perform channel decoding on the received constellation modulation symbols to recover the to-be-transmitted data.

Commonly used channel coding methods may include, for example, LDPC coding, polar coding, turbo coding, and convolutional coding. Low-density parity-check coding is defined by a sparse (or low-density) parity-check base matrix, and decoding performance can be improved through iterative decoding, for example, by using belief propagation decoding.

An LDPC code is a type of forward error correction coding. An LDPC code is a linear block code that may be defined by a base matrix and a lifting size. Since the parity-check matrix is very sparse, low-complexity decoding can be achieved. The parity-check matrix H of an LDPC code is a matrix with *m_{b}* × *Z* rows and *n_{b}* × *Z* columns. The matrix consists of *m_{b}* × *n_{b}* sub-matrices. Each sub-matrix is a power of a Z×Z standard permutation matrix (corresponding to a cyclic shift matrix of an identity matrix) or a Z×Z all-zero matrix. The parity-check matrix H has the following form: $H = \left[\begin{matrix}{P}^{{h}_{00}^{b}} & {P}^{{h}_{01}^{b}} & {P}^{{h}_{02}^{b}} & … & {P}^{{h}_{0 {n}_{b}}^{b}} \\ {P}^{{h}_{10}^{b}} & {P}^{{h}_{11}^{b}} & {P}^{{h}_{12}^{b}} & … & {P}^{{h}_{1 {n}_{b}}^{b}} \\ … & … & … & … & … \\ {P}^{{h}_{{m}_{b} 0}^{b}} & {P}^{{h}_{{m}_{b} 1}^{b}} & {P}^{{h}_{{m}_{b} 2}^{b}} & … & {P}^{{h}_{{m}_{b} {n}_{b}}^{b}}\end{matrix}\right] = {P}^{{H}_{b}} .$

If ${h}_{ij}^{b} = - 1 , {P}^{{h}_{ij}^{b}} = 0$; that is, the corresponding sub-matrix is a Z×Z all-zero matrix. If ${h}_{ij}^{b}$ is an integer greater than or equal to 0, the corresponding sub-matrix is a standard permutation matrix P raised to the power of ${h}_{ij}^{b}$ (that is, a cyclically shifted identity matrix). The Z×Z standard permutation matrix P is shown below (the identity matrix cyclically shifted one position to the right constitutes the standard permutation matrix). $P = \left[\begin{matrix}0 & 1 & 0 & … & 0 \\ 0 & 0 & 1 & … & 0 \\ … & … & … & … & … \\ 0 & 0 & 0 & … & 1 \\ 1 & 0 & 0 & … & 0\end{matrix}\right] .$

Therefore, each sub-matrix can be uniquely identified by ${h}_{ij}^{b}$*.* If a sub-matrix is an all-zero matrix, the corresponding ${h}_{ij}^{b}$ is represented by -1 (or by a null value or in another manner). If a sub-matrix is obtained by cyclic shift s of an identity matrix, the ${h}_{ij}^{b}$ equals s. In this manner, all ${h}_{ij}^{b}$ can form a base matrix. Accordingly, the base matrix includes two types of elements, that is, an element indicating an all-zero matrix and an element indicating a cyclic shift of an identity matrix.

Z is the dimension of the standard permutation matrix (sub-matrix) and may be referred to as a lifting size. The elements in the base matrix that indicate cyclic shifts of an identity matrix are replaced with "1", and all elements that indicate all-zero matrices are replaced with "0" so that a base graph matrix of an LDPC code (also referred to as an LDPC coding base graph matrix) can be obtained. Therefore, the base graph matrix of an LDPC code includes only two types of elements, that is, "0" and "1". Here, "0" is used to indicate that an element at a corresponding index position is an all-zero matrix, and "1 " is used to indicate that an element at a corresponding index position is a cyclically shifted identity matrix. For convenience of description, only the elements in the base matrix that indicate cyclic shifts of an identity matrix and the row and column index positions of these elements are described, while the remaining row and column index positions are by default elements indicating all-zero matrices. Alternatively, the elements indicating cyclic shifts of an identity matrix may be represented by cyclic shift values, while the elements indicating all-zero matrices may be represented by -1 or a null value.

For example, one LDPC coding base matrix (with 2 rows and 4 columns) is as follows, where the lifting size equals 4: $\left[\begin{matrix}0 & 3 & 0 & - 1 \\ 2 & 3 & 2 & 3\end{matrix}\right] .$

The parity-check matrix H is then as follows: $H = \left[\begin{matrix}\begin{matrix}1 & 0 & 0 & 0 \\ 0 & 1 & 0 & 0 \\ 0 & 0 & 1 & 0 \\ 0 & 0 & 0 & 1\end{matrix} & \begin{matrix}0 & 0 & 0 & 1 \\ 1 & 0 & 0 & 0 \\ 0 & 1 & 0 & 0 \\ 0 & 0 & 1 & 0\end{matrix} & \begin{matrix}1 & 0 & 0 & 0 \\ 0 & 1 & 0 & 0 \\ 0 & 0 & 1 & 0 \\ 0 & 0 & 0 & 1\end{matrix} & \begin{matrix}0 & 0 & 0 & 0 \\ 0 & 0 & 0 & 0 \\ 0 & 0 & 0 & 0 \\ 0 & 0 & 0 & 0\end{matrix} \\ \begin{matrix}0 & 0 & 1 & 0 \\ 0 & 0 & 0 & 1 \\ 1 & 0 & 0 & 0 \\ 0 & 1 & 0 & 0\end{matrix} & \begin{matrix}0 & 0 & 0 & 1 \\ 1 & 0 & 0 & 0 \\ 0 & 1 & 0 & 0 \\ 0 & 0 & 1 & 0\end{matrix} & \begin{matrix}0 & 0 & 1 & 0 \\ 0 & 0 & 0 & 1 \\ 1 & 0 & 0 & 0 \\ 0 & 1 & 0 & 0\end{matrix} & \begin{matrix}0 & 0 & 0 & 1 \\ 1 & 0 & 0 & 0 \\ 0 & 1 & 0 & 0 \\ 0 & 0 & 1 & 0\end{matrix}\end{matrix}\right] .$

The corresponding base graph matrix is as follows: $BG = \left[\begin{matrix}1 & 1 & 1 & 0 \\ 1 & 1 & 1 & 1\end{matrix}\right] .$

Since LDPC coding has parallel characteristics and thus supports parallel decoding, LDPC coding provides higher decoding throughput. The present application provides a spatially coupled LDPC (SC-LDPC) encoding method. A coupled parity-check matrix of a spatially coupled LDPC code may be expressed by the following formula: ${H}_{SC} = \left[\begin{matrix}{H}_{0}^{\left(0\right)} & & & & & & & \\ {H}_{1}^{\left(0\right)} & {H}_{0}^{\left(1\right)} & & & & & & \\ … & {H}_{1}^{\left(1\right)} & ⋱ & & & & & \\ {H}_{{m}_{s}}^{\left(0\right)} & ⋯ & ⋱ & {H}_{0}^{\left(L-1\right)} & & & & \\ & {H}_{{m}_{s}}^{\left(1\right)} & ⋱ & {H}_{1}^{\left(L-1\right)} & {T}_{0} & & & \\ & & ⋱ & {H}_{2}^{\left(L-1\right)} & & {T}_{1} & & \\ & & ⋱ & ⋯ & & & ⋯ & \\ & & & {H}_{{m}_{s}}^{\left(L-1\right)} & & & & {T}_{{m}_{s} - 1}\end{matrix}\right] .$

In the formula, L denotes a coupling chain length, *mₛ* denotes a coupling width (or coupling depth), elements in the coupled parity-check matrix ***H***_{SC} include at least 0 and 1, the coupled parity-check matrix ***H***_{SC} includes multiple sub-matrices that are not all zeros (such as check sub-matrices ${H}_{i}^{\left(t\right)}$ and tail check sub-matrices ***T**ⱼ*), and all elements other than ${H}_{i}^{\left(t\right)}$ and ***Tⱼ*** equal 0, where *i* = 0,1, ··· , *mₛ* - 1, *t* = 0,1, ··· , *L* - 1, and *j* = 0,1, ··· , *mₛ* - 1. The size of ${H}_{i}^{\left(t\right)}$ is m rows by n columns, and the size of ***Tⱼ*** is m rows by m columns, where *m* and *n* are positive integers. The number of rows in the coupled parity-check matrix of the spatially coupled LDPC code is (L+*mₛ*)**m*, and the number of columns is L**n*+*mₛ**m.

In a spatially coupled LDPC code, the forward check matrix of the *t*-th sub-codeblock may be expressed as ${H}_{s}^{t} = {\left[{H}_{0}^{\left(t\right)}, {H}_{1}^{\left(t\right)}, ⋯, {H}_{{m}_{s}}^{\left(t\right)}\right]}^{T}$, where the symbol 'T' denotes a transpose operation. For any index t, if the forward check matrix of the t-th sub-codeblock equals the forward check matrix of the (t+T)-th sub-codeblock, and the forward check matrices of the t-th to (t+T-1)-th sub-codeblocks are not equal to each other, the period of the spatially coupled LDPC code equals T, where T is a positive integer. If T equals 1, the spatially coupled LDPC coding may be regarded as time-invariant spatially coupled LDPC coding.

The encoding process of a spatially coupled LDPC code is as follows: Spatially coupled LDPC coding is performed on input information to obtain an encoded sequence C. The encoded sequence satisfies the following equation: ***H***_{SC} × ***C*** = **0**, where ***C*** is an encoded output sequence, **0** is an all-zero vector, and ***H***_{SC} is a coupled parity-check matrix. The encoded sequence may be divided into (L+*mₛ*) codeblocks, which correspond to L sub-codeblocks and *mₛ* tail codeblocks, respectively. The length of each of the L sub-codeblocks equals *n*, and the length of each of the *mₛ* tail codeblocks equals *m*. In the spatially coupled LDPC encoded sequence, the sub-matrix group in the coupled parity-check matrix ***H***_{SC} that is not all zeros and that corresponds to the t-th sub-codeblock is ***H***₀^{(*t*)}, ... , ***H**_{mₛ}*^{(*t*)}, where the top-left element of ${H}_{0}^{\left(t\right)}$ is located at row index t*m and column index t*n in ***H***_{SC}, and t is a non-negative integer less than L. In the spatially coupled LDPC encoded sequence, the sub-matrix in the coupled parity-check matrix ***H***_{SC} that is not all zeros and that corresponds to the *j*-th tail codeblock is ***T**ⱼ*, where the top-left element of ***T**ⱼ* is located at row index *t***m* and column index *t***n* in ***H***_{SC}, and *t* is a non-negative integer less than *L*. Unless otherwise specified, all variables herein are counted starting from 0.

Furthermore, in the spatially coupled LDPC encoded sequence, the sub-matrix group in the coupled parity-check matrix ***H***_{SC} that is not all zeros and that corresponds to the *t*-th codeblock is ***H***₀^{(*t*)}, *..., **H**_{mₛ}*^{(*t*)}*.* The sub-matrix group is determined by multiple sub-base matrices $H {b}_{0}^{\left(t\right)} , ⋯ , H {b}_{{m}_{s}}^{\left(t\right)}$ and the lifting size Z. The i-th sub-matrix ${H}_{i}^{\left(t\right)}$ is determined by the i-th sub-base matrix $H {b}_{i}^{\left(t\right)}$ and the lifting size Z. That is, elements in the i-th sub-base matrix $H {b}_{i}^{\left(t\right)}$ that indicate all-zero matrices are replaced with all-zero matrices of Z rows and Z columns, and elements that indicate cyclic shifts of an identity matrix are replaced with matrices of Z rows and Z columns obtained by cyclic shifting of an identity matrix. In this manner, the i-th sub-matrix ${H}_{i}^{\left(t\right)}$ is obtained, where i = 0,1, ··· , *mₛ* - 1, and *t* = 0,1, ··· , *L -* 1. In the spatially coupled LDPC encoded sequence, the sub-matrix in the coupled parity-check matrix ***H***_{SC} that is not all zeros and that corresponds to the j-th tail codeblock is ***T**ⱼ,* and the sub-matrix is determined by a tail sub-base matrix ***T**bⱼ* and the lifting size Z. Elements in the tail sub-base matrix ***T**bⱼ* that indicate all-zero matrices are replaced with all-zero matrices of Z rows and Z columns, and elements that indicate cyclic shifts of an identity matrix are replaced with matrices of Z rows and Z columns obtained by cyclic shifting of an identity matrix. In this manner, ***T**ⱼ* can be obtained, where *j* = 0,1, ··· , *mₛ* - 1. Therefore, a spatially coupled LDPC code may be determined by multiple sub-base matrices, multiple tail sub-base matrices, and the lifting size Z. A spatially coupled LDPC coding base matrix is composed of multiple sub-base matrices and multiple tail sub-base matrices and can be expressed as follows: $H {b}_{SC} = \left[\begin{matrix}H {b}_{0}^{\left(0\right)} & & & & & & & \\ H {b}_{1}^{\left(0\right)} & H {b}_{0}^{\left(1\right)} & & & & & & \\ … & H {b}_{1}^{\left(1\right)} & ⋱ & & & & & \\ H {b}_{{m}_{s}}^{\left(0\right)} & ⋯ & ⋱ & H {b}_{0}^{\left(L-1\right)} & & & & \\ & H {b}_{{m}_{s}}^{\left(1\right)} & ⋱ & H {b}_{1}^{\left(L-1\right)} & T {b}_{0} & & & \\ & & ⋱ & H {b}_{2}^{\left(L-1\right)} & & T {b}_{1} & & \\ & & ⋱ & ⋯ & & & ⋯ & \\ & & & H {b}_{{m}_{s}}^{\left(L-1\right)} & & & & T {b}_{{m}_{s} - 1}\end{matrix}\right] .$

In the expression, L denotes a coupling chain length, *mₛ* denotes a coupling width (or coupling depth), elements in the spatially coupled LDPC coding base matrix ***H**b*_{SC} include at least elements indicating all-zero matrices and elements indicating cyclic shifts of an identity matrix. Generally, elements indicating all-zero matrices may be represented by -1, null, an empty value, or other values, and elements indicating cyclic shifts of an identity matrix are non-negative integers less than Z and are used to indicate the size of the cyclic shift. The spatially coupled LDPC coding base matrix ***H**b*_{SC} includes multiple sub-matrices that are not entirely composed of elements indicating all-zero matrices (such as $H {b}_{i}^{\left(t\right)}$ and ***T**bⱼ*), and all elements other than $H {b}_{i}^{\left(t\right)}$ and ***T**bⱼ* are elements indicating all-zero matrices, where *i* = 0,1, ··· , *mₛ* - 1 , *t* = 0,1, ··· , *L* - 1, and *j* = 0,1, ··· , *mₛ* - 1. The size of $H {b}_{i}^{\left(t\right)}$ is mb rows by nb columns, and the size of ***T**bⱼ* is mb rows by nb columns, where mb and nb are positive integers. The number of rows in the spatially coupled LDPC coding base matrix is (L+*mₛ*)*mb, and the number of columns is *L**nb+*mₛ**mb. The elements indicating all-zero matrices may be represented by a null value (null), -1, or ∞.

In the spatially coupled LDPC coding base matrix, all elements that indicate all-zero matrices are set to 0, and all elements that indicate cyclic shifts of an identity matrix are set to 1 so that a spatially coupled LDPC coding base graph matrix can be obtained. Correspondingly, in a spatially coupled LDPC code, the forward check base graph matrix of the t-th sub-codeblock can be expressed as $B {G}_{s}^{t} = {\left[B{G}_{0}^{\left(t\right)},B{G}_{1}^{\left(t\right)},⋯,B{G}_{{m}_{s}}^{\left(t\right)}\right]}^{T}$, where the symbol 'T' denotes a transpose operation. The period of the spatially coupled LDPC coding base graph matrix can be determined according to differences among the forward check base graph matrices of each sub-codeblock. Specifically, for any index t, if the forward check base graph matrix of the t-th sub-codeblock equals the forward check base graph matrix of the (*t+T*)-th sub-codeblock, and the forward check base graph matrices from the t-th to (*t+T-1*)-th sub-codeblocks are not equal to each other, the period of the spatially coupled LDPC coding base graph matrix equals T, where T is a positive integer. If T equals 1, the spatially coupled LDPC coding may be regarded as time-invariant spatially coupled LDPC coding with respect to the base graph matrix. Similarly, for any index t, if the forward check base matrix of the t-th sub-codeblock equals the forward check base matrix of the (*t+T*)-th sub-codeblock, and the forward check base matrices from the t-th to (*t+T-1*)-th sub-codeblocks are not equal to each other, the period of the spatially coupled LDPC coding base matrix equals T, where T is a positive integer. If T equals 1, the spatially coupled LDPC coding may be regarded as time-invariant spatially coupled LDPC coding with respect to the base matrix.

For a spatially coupled LDPC code, for any two different sub-codeblock indices t1 and t2, if the sub-matrix group that is not all zeros and that corresponds to the t1-th sub-codeblock is ${H}_{0}^{\left(t1\right)} , ⋯ , {H}_{{m}_{s}}^{\left(t1\right)}$ (corresponding to $H {b}_{0}^{\left(t1\right)} , ⋯ , H {b}_{{m}_{s}}^{\left(t1\right)}$ in the base matrix), and the sub-matrix group that is not all zeros and that corresponds to the t2-th sub-codeblock is ${H}_{0}^{\left(t2\right)} , ⋯ , {H}_{{m}_{s}}^{\left(t2\right)}$ (corresponding to $H {b}_{0}^{\left(t2\right)} , ⋯ , H {b}_{{m}_{s}}^{\left(t2\right)}$ in the base matrix), ${H}_{i}^{\left(t1\right)}$ equals to ${H}_{i}^{\left(t2\right)}$ (corresponding to the case where in the base matrix, $H {b}_{i}^{\left(t1\right)}$ equals $H {b}_{i}^{\left(t2\right)}$), and *i* = 0,1, ··· , *mₛ* - 1 , the encoding can be referred to as time-invariant spatially coupled LDPC coding. Spatially coupled LDPC coding may be performed according to the spatially coupled LDPC coding base matrix and the lifting size Z to obtain an encoded sequence.

The data transmission method and apparatus, and the storage medium provided by embodiments of the present application may be used for various types of user equipment (UE), may be used in future mobile communications (for example, B5G, 6G, or 7G), and may also be used in digital video broadcasting systems or optical fiber communication systems. The various types of UE may also include or be referred to by those skilled in the art as mobile stations, user stations, mobile units, user units, wireless units, remote units, mobile devices, wireless devices, wireless communication devices, remote devices, mobile user stations, access terminals, mobile terminals, wireless terminals, remote terminals, handheld apparatuses, user agents, mobile clients, clients, passive tags, or some other suitable terms. In addition, the various types of UE may be cellular telephones, personal digital assistants (PDAs), wireless modems, wireless communication devices, handheld devices, tablet computers, laptop computers, cordless telephones, wireless local loop (WLL) stations, and so on. The various types of UE may communicate with various types of base stations and network devices (including macro eNBs, small cell eNBs, and relay base stations).

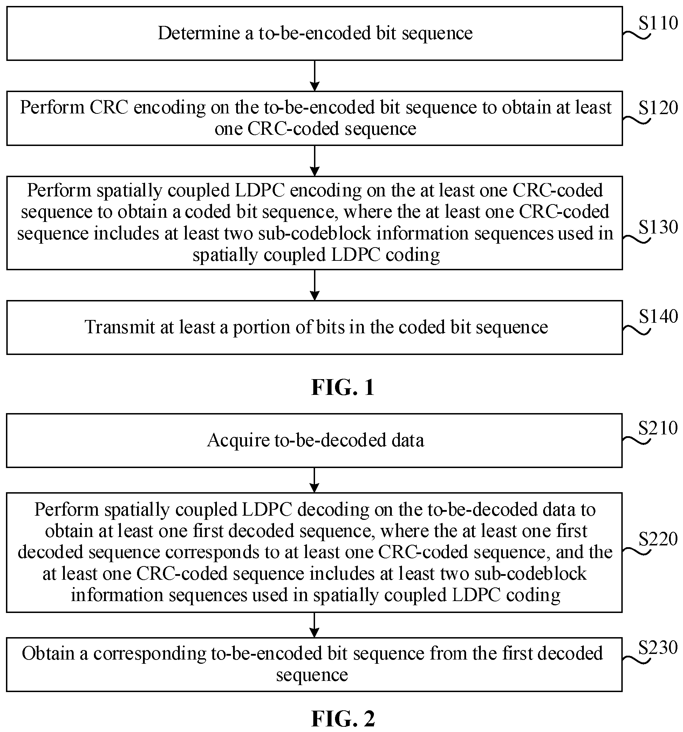

In an embodiment, FIG. 1 is a flowchart of a data transmission method according to an embodiment of the present application. This embodiment is applied to encoding under conditions such as improving ultra-high throughput decoding and reducing decoding power consumption. This embodiment may be performed by a first communication device. As shown in FIG. 1, this embodiment includes S110 to S140.

In S110, a to-be-encoded bit sequence is determined.

In S120, CRC encoding is performed on the to-be-encoded bit sequence to obtain at least one CRC-coded sequence.

In S130, spatially coupled LDPC encoding is performed on the at least one CRC-coded sequence to obtain a coded bit sequence, where the at least one CRC-coded sequence includes at least two sub-codeblock information sequences used in spatially coupled LDPC coding.

In S140, at least a portion of bits in the coded bit sequence is transmitted.

In an example, the coded bit sequence refers to a bit sequence after encoding. At least one CRC-coded sequence is denoted as X CRC-coded sequences. The first communication device performs CRC encoding on the to-be-encoded bit sequence to obtain X CRC-coded sequences, performs spatially coupled LDPC encoding on the X CRC-coded sequences to obtain a coded bit sequence, and transmits the coded bit sequence or a portion of the bits in the coded bit sequence. In an example, at least one of the X CRC-coded sequences includes at least two sub-codeblock information sequences used in the spatially coupled LDPC coding.

In an embodiment, at least one CRC-coded sequence includes a first preset number of sub-codeblock information sequences used in the spatially coupled LDPC coding, where the first preset number is an even number greater than 0. In an example, the first preset number is denoted as Y0. Any one of the X CRC-coded sequences includes at least Y0 sub-codeblock information sequences used in the spatially coupled LDPC coding, where Y0 is an integer greater than 1 or Y0 is a positive integer power of 2.

In an embodiment, the CRC-coded sequence includes at least two sub-codeblock information sequences used in the spatially coupled LDPC coding, where the at least two sub-codeblock information sequences are consecutive sub-codeblock information sequences in the spatially coupled LDPC coding, that is, all sub-codeblocks corresponding to the at least two sub-codeblock information sequences are pairwise adjacent. In an example, the Y0 sub-codeblock information sequences in the spatially coupled LDPC coding are consecutive sub-codeblock information sequences.

In an embodiment, at least one CRC-coded sequence includes a second preset number of sub-codeblock information sequences used in the spatially coupled LDPC coding, where the second preset number is a positive integer multiple of a period of a base graph matrix of the spatially coupled LDPC coding, or is a positive integer multiple of a period of a base matrix of the spatially coupled LDPC coding, or is a positive integer multiple of the product of a period of a base graph matrix of the spatially coupled LDPC coding and a period of a base matrix of the spatially coupled LDPC coding. In an example, it is assumed that the second preset number is Y2, the period of the base graph matrix of the spatially coupled LDPC coding is denoted as T0, and the period of the base matrix of the spatially coupled LDPC coding is denoted as T1, where both T0 and T1 are positive integers. In at least one of the X CRC-coded sequences, all bits are placed in Y2 consecutive sub-codeblock information sequences in the spatially coupled LDPC coding, where Y2 may be a positive integer multiple of T0, may be a positive integer multiple of T1, or may be a positive integer multiple of T0*T1.

In an embodiment, the number of bits included in a CRC-coded sequence is determined by at least one of following parameters: the length of a sub-codeblock information sequence of the spatially coupled LDPC coding; the number of systematic bits of a sub-codeblock of the spatially coupled LDPC coding; the number of sub-codeblocks of the spatially coupled LDPC coding; the length of the to-be-encoded bit sequence; the number of CRC parity bits; a transport block size; a period of a base graph matrix of the spatially coupled LDPC coding; a period of a base matrix of the spatially coupled LDPC coding; the maximum number of bits of an information sequence of the CRC encoding; the maximum number of bits of a CRC-coded sequence; or a code rate. The number of CRC parity bits refers to the number of bits included in a CRC parity bit sequence in the CRC-coded sequence.

In an embodiment, the number of bits included in at least one CRC-coded sequence is equal to the sum of lengths of a third preset number of sub-codeblock information sequences used in the spatially coupled LDPC coding, where the third preset number is an integer greater than 1 and less than or equal to the number of sub-codeblocks of the spatially coupled LDPC coding. In an example, the third preset number is denoted as Y1 or Y2. In an example, X1 CRC-coded sequences exist among the X CRC-coded sequences, and the number of bits in each of the X1 CRC-coded sequences equals the sum of the lengths of Y1 sub-codeblock information sequences used in the spatially coupled LDPC coding. In an example, X2 CRC-coded sequences exist among the X CRC-coded sequences, and the number of bits in each of the X2 CRC-coded sequences equals the sum of the lengths of Y2 sub-codeblock information sequences used in the spatially coupled LDPC coding. X1 and X2 are both non-negative integers, and the sum of X1 and X2 equals X. Y1 and Y2 are both non-negative integers, and the sum of Y1 and Y2 equals L, where L is the number of sub-codeblocks of the spatially coupled LDPC coding. In an example, the difference between Y1 and Y2 is not greater than 1.

In an embodiment, the number of CRC-coded sequences is determined by at least one of following parameters: the length of a sub-codeblock information sequence of the spatially coupled LDPC coding; the number of systematic bits of a sub-codeblock of the spatially coupled LDPC coding; the number of sub-codeblocks of the spatially coupled LDPC coding; the length of the to-be-encoded bit sequence; the number of CRC parity bits; a transport block size; a period of a base graph matrix of the spatially coupled LDPC coding; a period of a base matrix of the spatially coupled LDPC coding; the maximum number of bits of an information sequence of the CRC encoding; the maximum number of bits of a CRC-coded sequence; or a code rate.

In an embodiment, in the CRC encoding, at least two CRC-coded sequences are obtained, and numbers of sub-codeblock information sequences included in every two CRC-coded sequences among the at least two CRC-coded sequences are equal to each other.

In an embodiment, in the CRC encoding, at least one CRC-coded sequence is obtained, where the number of bits in at least one CRC-coded sequence is greater than the length of a sub-codeblock information sequence of the spatially coupled LDPC coding. In a specific example, in the CRC encoding, at least one CRC-coded sequence is obtained, where the number of bits in at least one CRC-coded sequence is greater than or equal to H times the length of a sub-codeblock information sequence of the spatially coupled LDPC coding, where H is an integer greater than 1. The length of a sub-codeblock information sequence of the spatially coupled LDPC coding is an integer greater than 0. In a specific example, H equals at least one of the following: 2, 3, 4, 5, 6, 7, 8, 10, 12, 14, 16, 20, 24, or 32.

In an embodiment, the maximum number of bits of a CRC-coded sequence is greater than the number of systematic bits of a sub-codeblock of the spatially coupled LDPC coding. In a specific example, the maximum number of bits of a CRC-coded sequence is greater than or equal to W times the number of systematic bits of a sub-codeblock of the spatially coupled LDPC coding, where W equals at least one of the following: 2, 3, 4, 5, 6, 7, 8, 10, 12, 14, 16, 20, 24, or 32. The maximum number of bits of a CRC-coded sequence is an integer greater than 0, and the number of systematic bits of a sub-codeblock of the spatially coupled LDPC coding is an integer greater than 0.

In an embodiment, in CRC encoding, at least two CRC-coded sequences are obtained, a first value is the maximum value of numbers of sub-codeblock information sequences included in the at least two CRC-coded sequences, and a second value is the minimum value of numbers of sub-codeblock information sequences included in the at least two CRC-coded sequences, where the maximum difference between the first value and the second value is equal to 1.

In an embodiment, in the CRC encoding, a fourth preset number of CRC-coded sequences are obtained, where numbers of sub-codeblock information sequences included in a fifth preset number of CRC-coded sequences are equal, the fourth preset number is an integer greater than 1, and the fifth preset number is obtained by subtracting one from the fourth preset number. In an example, assuming the fourth preset number is X, the fifth preset number is X-1. When CRC encoding is performed on the to-be-encoded bit sequence to obtain X CRC-coded sequences, the numbers of sub-codeblock information sequences included in the first (X-1) CRC-coded sequences are equal.

In an embodiment, the number of sub-codeblocks of the spatially coupled LDPC coding is an integer greater than 1. In a specific example, the minimum number of sub-codeblocks of the spatially coupled LDPC coding equals one of the following: 4, 6, 8, 10, 12, 16, 24, or 32.

In an embodiment, the maximum number of bits of a CRC-coded sequence is an integer greater than or equal to 2048. In a specific example, the maximum number of bits of a CRC-coded sequence may include at least one of the following: 4096, 6144, 8192, 8448, or 16384.

In an embodiment, the maximum number of bits of an information sequence of the CRC encoding is an integer greater than 1024 and less than or equal to 16384.

In an embodiment, the length of a sub-codeblock information sequence of the spatially coupled LDPC coding is an integer greater than or equal to 128 and less than or equal to 8448.

In an embodiment, the number of systematic bits of a sub-codeblock of the spatially coupled LDPC coding equals at least one of the following: 128, 256, 400, 512, 600, 800, 1024, 1536, 2048, 3072, or 4096. The sub-codeblock systematic bits include an information sequence and padding bits in a sub-codeblock of the spatially coupled LDPC coding. That is, the number of sub-codeblock systematic bits equals the sum of the length of the information sequence and the number of padding bits in the sub-codeblock of the spatially coupled LDPC coding. The number of padding bits is a non-negative integer. If no padding is required, the number of padding bits equals 0.

In an embodiment, the number of CRC-coded sequences is at least equal to 2.

In an embodiment, the number of CRC parity bits in a CRC-coded sequence includes at least one of the following: 6, 8, 11, 12, 14, 16, 18, 20, 24, or 32.

In an embodiment, the number of sub-codeblock information sequences included in a CRC-coded sequence includes one of the following: 2, 4, 6, 8, 10, 12, 14, 16, 18, 20, or 24. In an example, Y0 may equal 2, 4, 6, 8, 10, 12, 14, 16, 18, 20, or 24.

In an embodiment, the maximum number of sub-codeblock information sequences included in a CRC-coded sequence equals at least one of the following: 4, 6, 8, 10, 12, 14, 16, 18, 20, or 24.

In an example, the length of a sub-codeblock information sequence of the spatially coupled LDPC coding may include at least one of the following: 128, 256, 400, 600, 512, 768, 800, 1024, 2048, or 4096.

In an embodiment, FIG. 2 is a flowchart of another data transmission method according to an embodiment of the present application. This embodiment is applied to coding under conditions such as improving ultra-high throughput decoding and reducing decoding power consumption. This embodiment may be performed by a second communication device. As shown in FIG. 2, this embodiment includes S210 to S230.

In S210, to-be-decoded data is acquired.

In S220, spatially coupled LDPC decoding is performed on the to-be-decoded data to obtain at least one first decoded sequence, where the at least one first decoded sequence corresponds to at least one CRC-coded sequence, and the at least one CRC-coded sequence includes at least two sub-codeblock information sequences used in spatially coupled LDPC coding.

In S230, a corresponding to-be-encoded bit sequence is obtained from the first decoded sequence.

A corresponding to-be-encoded bit sequence can be obtained by performing CRC decoding on the first decoded sequence.

In an embodiment, at least one CRC-coded sequence includes a first preset number of sub-codeblock information sequences used in the spatially coupled LDPC coding, where the first preset number is an even number greater than 0. In an example, the first preset number is denoted as Y0. In any one of the X CRC-coded sequences, at least Y0 sub-codeblock information sequences used in the spatially coupled LDPC coding are included.

In an embodiment, the at least one CRC-coded sequence includes at least two sub-codeblock information sequences used in the spatially coupled LDPC coding, where the at least two sub-codeblock information sequences are consecutive sub-codeblock information sequences in the spatially coupled LDPC coding, that is, all sub-codeblocks corresponding to the at least two sub-codeblock information sequences are pairwise adjacent. In an example, the Y0 sub-codeblock information sequences in the spatially coupled LDPC coding are consecutive sub-codeblock information sequences.

In an embodiment, at least one CRC-coded sequence includes a second preset number of sub-codeblock information sequences used in the spatially coupled LDPC coding, where the second preset number is a positive integer multiple of a period of a base graph matrix of the spatially coupled LDPC coding, or is a positive integer multiple of a period of a base matrix of the spatially coupled LDPC coding, or is a positive integer multiple of the product of a period of a base graph matrix of the spatially coupled LDPC coding and a period of a base matrix of the spatially coupled LDPC coding. In an example, it is assumed that the second preset number is Y2, the period of the base graph matrix of the spatially coupled LDPC coding is denoted as T0, and the period of the base matrix of the spatially coupled LDPC coding is denoted as T1, where both T0 and T1 are positive integers. In at least one of the X CRC-coded sequences, all bits are placed in Y2 consecutive sub-codeblock information sequences in the spatially coupled LDPC coding, where Y2 may be a positive integer multiple of T0, may be a positive integer multiple of T1, or may be a positive integer multiple of T0*T1.

In an embodiment, the number of bits included in a CRC-coded sequence is determined by at least one of following parameters: the length of a sub-codeblock information sequence of the spatially coupled LDPC coding; the number of systematic bits of a sub-codeblock of the spatially coupled LDPC coding; the number of sub-codeblocks of the spatially coupled LDPC coding; the length of the to-be-encoded bit sequence; the number of CRC parity bits; a transport block size; a period of a base graph matrix of the spatially coupled LDPC coding; a period of a base matrix of the spatially coupled LDPC coding; the maximum number of bits of an information sequence of the CRC encoding; the maximum number of bits of a CRC-coded sequence; or a code rate.

In an embodiment, the number of bits included in at least one CRC-coded sequence is equal to the sum of lengths of a third preset number of sub-codeblock information sequences used in the spatially coupled LDPC coding, where the third preset number is an integer greater than 1 and less than or equal to the number of sub-codeblocks of the spatially coupled LDPC coding. In an example, the third preset number is denoted as Y1 or Y2. In an example, X1 CRC-coded sequences exist among the X CRC-coded sequences, and the number of bits in each of the X1 CRC-coded sequences equals the sum of the lengths of Y1 sub-codeblock information sequences used in the spatially coupled LDPC coding. In an example, X2 CRC-coded sequences exist among the X CRC-coded sequences, and the number of bits in each of the X2 CRC-coded sequences equals the sum of the lengths of Y2 sub-codeblock information sequences used in the spatially coupled LDPC coding. X1 and X2 are both non-negative integers, and the sum of X1 and X2 equals X. Y1 and Y2 are both non-negative integers, and the sum of Y1 and Y2 equals L, where L is the number of sub-codeblocks of the spatially coupled LDPC coding. In an example, the difference between Y1 and Y2 is not greater than 1.

In an embodiment, the number of CRC-coded sequences is determined by at least one of following parameters: the length of a sub-codeblock information sequence of the spatially coupled LDPC coding; the number of systematic bits of a sub-codeblock of the spatially coupled LDPC coding; the number of sub-codeblocks of the spatially coupled LDPC coding; the length of the to-be-encoded bit sequence; the number of CRC parity bits; a transport block size; a period of a base graph matrix of the spatially coupled LDPC coding; a period of a base matrix of the spatially coupled LDPC coding; the maximum number of bits of an information sequence of the CRC encoding; the maximum number of bits of a CRC-coded sequence; or a code rate.

In an example, the code rate is a real number greater than 0 and less than 1. In a specific example, the code rate is determined by a modulation and coding scheme (MCS) index.

In an embodiment, in the CRC encoding, at least two CRC-coded sequences are obtained, and numbers of sub-codeblock information sequences included in every two CRC-coded sequences among the at least two CRC-coded sequences are equal to each other.

In an embodiment, in the CRC encoding, at least one CRC-coded sequence is obtained, where the number of bits in at least one CRC-coded sequence is greater than the length of a sub-codeblock information sequence of the spatially coupled LDPC coding. In a specific example, in the CRC encoding, at least one CRC-coded sequence is obtained, where the number of bits in at least one CRC-coded sequence is greater than or equal to H times the length of a sub-codeblock information sequence of the spatially coupled LDPC coding, where H is an integer greater than 1. The length of a sub-codeblock information sequence of the spatially coupled LDPC coding is an integer greater than 0. In a specific example, H equals at least one of the following: 2, 3, 4, 5, 6, 7, 8, 10, 12, 14, 16, 20, 24, or 32.

In an embodiment, the maximum number of bits of a CRC-coded sequence is greater than the number of systematic bits of a sub-codeblock of the spatially coupled LDPC coding. In a specific example, the maximum number of bits of a CRC-coded sequence is greater than or equal to W times the number of systematic bits of a sub-codeblock of the spatially coupled LDPC coding, where W equals at least one of the following: 2, 3, 4, 5, 6, 7, 8, 10, 12, 14, 16, 20, 24, or 32. The maximum number of bits of a CRC-coded sequence is an integer greater than 0, and the number of systematic bits of a sub-codeblock of the spatially coupled LDPC coding is an integer greater than 0.

In an embodiment, in CRC encoding, at least two CRC-coded sequences are obtained, a first value is the maximum value of numbers of sub-codeblock information sequences included in the at least two CRC-coded sequences, and a second value is the minimum value of numbers of sub-codeblock information sequences included in the at least two CRC-coded sequences, where the maximum difference between the first value and the second value is equal to 1.

In an embodiment, in the CRC encoding, a fourth preset number of CRC-coded sequences are obtained, where numbers of sub-codeblock information sequences included in a fifth preset number of CRC-coded sequences are equal, the fourth preset number is an integer greater than 1, and the fifth preset number is obtained by subtracting one from the fourth preset number. In an example, assuming the fourth preset number is X, the fifth preset number is X-1. When CRC encoding is performed on the to-be-encoded bit sequence to obtain X CRC-coded sequences, the numbers of sub-codeblock information sequences included in the first (X-1) CRC-coded sequences are equal.

In an embodiment, the number of sub-codeblocks of the spatially coupled LDPC coding is an integer greater than 1. In a specific example, the minimum number of sub-codeblocks of the spatially coupled LDPC coding equals one of the following: 4, 6, 8, 10, 12, 16, 24, or 32.

In an embodiment, the maximum number of bits of a CRC-coded sequence includes at least one of the following: 4096, 6144, 8192, 8448, or 16384.

In an embodiment, the maximum number of bits of an information sequence of the CRC encoding is an integer greater than 1024 and less than or equal to 16384.

In an embodiment, the length of a sub-codeblock information sequence of the spatially coupled LDPC coding is an integer greater than or equal to 128 and less than or equal to 8448.

In an embodiment, the number of systematic bits of a sub-codeblock of the spatially coupled LDPC coding equals at least one of the following: 128, 256, 400, 512, 600, 800, 1024, 1536, 2048, 3072, or 4096. The sub-codeblock systematic bits include an information sequence and padding bits in a sub-codeblock of the spatially coupled LDPC coding. That is, the number of sub-codeblock systematic bits equals the sum of the length of the information sequence and the number of padding bits in the sub-codeblock of the spatially coupled LDPC coding. The number of padding bits is a non-negative integer. If no padding is required, the number of padding bits equals 0.

In an embodiment, the number of CRC-coded sequences is at least equal to 2.

In an embodiment, the number of CRC parity bits in a CRC-coded sequence includes at least one of the following: 6, 8, 11, 12, 14, 16, 18, 20, 24, or 32.

In an embodiment, the number of sub-codeblock information sequences included in a CRC-coded sequence includes one of the following: 2, 4, 6, 8, 10, 12, 14, 16, 18, 20, or 24. In an example, Y0 may equal 2, 4, 6, 8, 10, 12, 14, 16, 18, 20, or 24.

In an embodiment, the maximum number of sub-codeblock information sequences included in a CRC-coded sequence equals at least one of the following: 4, 6, 8, 10, 12, 14, 16, 18, 20, or 24.

In an example, the length of a sub-codeblock information sequence of the spatially coupled LDPC coding may include at least one of the following: 128, 256, 400, 600, 512, 768, 800, 1024, 2048, or 4096.

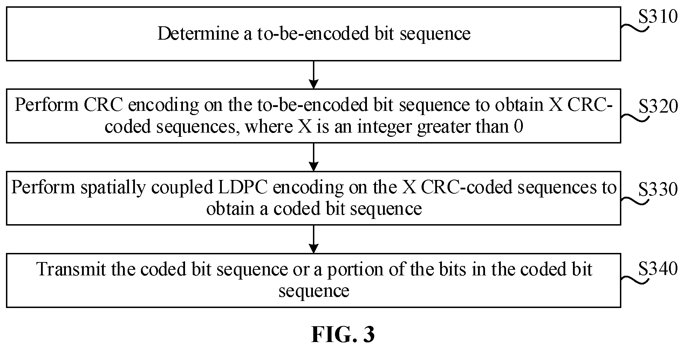

In embodiment one, FIG. 3 is a flowchart of another data transmission method according to an embodiment of the present application. The data transmission process is described in this embodiment. In this embodiment, a data transmission method is illustrated. As shown in FIG. 3, the data transmission method includes S310 to S340.

In S310, a to-be-encoded bit sequence is determined.

The to-be-encoded bit sequence may be a bit sequence to which a transport block-level CRC has been added, or may be a bit sequence to which no transport block-level CRC has been added. In an example, the to-be-encoded bit sequence is denoted as *a*₀, *a*₁, *a*₂, *a*₃, . . . , *a*_{*A-*1}, and the number of bits is A, where A is an integer greater than 0.

In S320, CRC encoding is performed on the to-be-encoded bit sequence to obtain X CRC-coded sequences, where X is an integer greater than 0.

The to-be-encoded bit sequence is first divided into X sub-bit sequences. CRC encoding is then performed on each of the X sub-bit sequences to obtain X CRC-coded sequences. CRC encoding produces a CRC parity bit sequence with a bit length equal to *L*crc. The CRC parity bit sequence is combined with a sub-bit sequence to obtain a CRC-coded sequence. The generator polynomials used for the CRC encoding include (but are not limited to) one of the following:

*g*_{CRC24A}(*D*) = [*D*²⁴ + *D*²³ + *D*¹⁸ + *D*¹⁷ + *D*¹⁴ + *D*¹¹ + *D*¹⁰ + *D*⁷ + *D*⁶ + *D*⁵ + *D*⁴ + *D*³ *+ D* + 1], where the number of CRC parity bits is *L*crc = 24; *g*_{CRC24B}(*D*) = [*D*²⁴ + *D*²³ + *D*⁶ *+ D*⁵ *+ D* + 1], where the number of CRC parity bits is *L*crc = 24; *g*_{CRC24C}(*D*) = [*D*²⁴ + *D*²³ + *D*²¹ + *D*²⁰ *+ D*¹⁷ *+ D*¹⁵ + *D*¹³ + *D*¹² *+ D*⁸ *+ D*⁴ *+ D*² *+ D +* 1], where the number of CRC parity bits is *L*crc = 24; *g*_{CRC16}(*D*) = [*D*¹⁶ + *D*¹² + *D*⁵ + 1], where the number of CRC parity bits is *L*crc = 16; *g*_{CRC12A}(*D*) = [*D*¹² + *D*⁶ + *D*⁴ + *D*¹ + 1], where the number of CRC parity bits is *L*crc = 12; *g*_{CRC12B}(*D*) = [*D*¹² *+ D*¹¹ *+ D*⁷ *+ D*⁴ + 1], where the number of CRC parity bits is *L*crc = 12; *g*_{CRC12C}(D) = [*D*¹² + *D*¹¹ + *D*¹⁰ *+ D*⁹ *+ D*⁸ *+ D*⁷ *+ D*⁶ + *D*³ + 1], where the number of CRC parity bits is *L*crc = 12;*g*_{CRC11}*(D)* = [*D*¹¹ *+ D*¹⁰ + *D*⁹ + *D*⁵ + 1], where the number of CRC parity bits is *L*crc = 11; *g*_{CRC8A}(D) = [*D*⁸ *+ D*⁶ + *D*⁴ + *D*³ + *D*² + *D*¹ + 1], where the number of CRC parity bits is *L*crc = 8; *g*_{CRC8B}(*D*) = [*D*⁸ + *D*⁵ + *D*³ + *D*¹ + 1], where the number of CRC parity bits is *L*crc = 8; *g*_{CRC6}(*D*) = [*D*⁶ *+ D*⁵ + 1], where the number of CRC parity bits is *L*crc = 6.

The number *L*crc (which may also be abbreviated as L) of CRC parity bits may include one of the following: 6, 8, 11, 12, 14, 16, 18, 20, 24, or 32.

After CRC encoding is performed on the to-be-encoded bit sequence *a*₀, *a*₁, *a*₂, *a*₃, . . . , *a*_{*A*-1}, X CRC-coded sequences are obtained. The i-th CRC-coded sequence is denoted as ${b}_{0}^{i} , {b}_{1}^{i} , {b}_{2}^{i} , {b}_{3}^{i} , … , {b}_{B - 1}^{i}$ and has a length of B, where B is an integer greater than 0. The number of bits B in the CRC-coded sequence is determined by at least one of the following parameters: the length of a sub-codeblock information sequence of the spatially coupled LDPC coding, the number of systematic bits of a sub-codeblock of the spatially coupled LDPC coding, the number of sub-codeblocks of the spatially coupled LDPC coding, the length of the to-be-encoded bit sequence, the number of CRC parity bits, a transport block size, a period of a base graph matrix of the spatially coupled LDPC coding, a period of a base matrix of the spatially coupled LDPC coding, the maximum number of bits of a CRC-coded sequence, or a code rate.

In an example, the code rate is a real number greater than 0 and less than 1. In a specific example, the code rate is determined by an MCS index.

In an example, the number of bits in the CRC-coded sequence is determined by the length of a sub-codeblock information sequence of the spatially coupled LDPC coding. In an example, the number of bits in the CRC-coded sequence equals *K* · *Y*, where *K* is the length of a sub-codeblock information sequence of the spatially coupled LDPC coding, and *Y* is an integer greater than 1. In this example, the length *K* of a sub-codeblock information sequence of the spatially coupled LDPC coding equals 512, and the number of bits in the CRC-coded sequence equals a positive integer multiple of *K*.

In an example, in the X CRC-coded sequences, the difference between the maximum number of bits and the minimum number of bits is not greater than K, where K is the information bit length of a sub-codeblock of the spatially coupled LDPC coding. In another example, the number of bits in all CRC-coded sequences among the X CRC-coded sequences is equal, that is, the difference between the maximum number of bits and the minimum number of bits equals 0.

In S330, spatially coupled LDPC coding is performed on the X CRC-coded sequences to obtain a coded bit sequence.

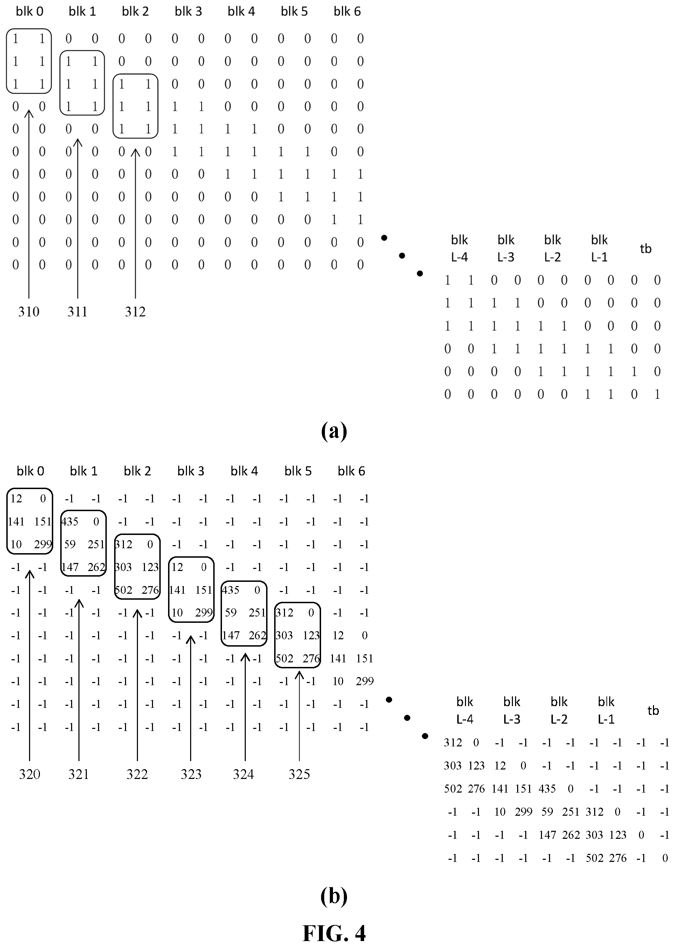

FIG. 4 is a diagram illustrating the configuration of a base matrix and a base graph matrix for spatially coupled LDPC coding according to an embodiment of the present application. In FIG. 4, (a) shows an example of a base graph matrix of spatially coupled LDPC coding in this example, and (b) shows an example of a base matrix of spatially coupled LDPC coding in this example. It can be seen that the period of the base graph matrix of spatially coupled LDPC coding equals 1. This is because the forward check base graph matrix corresponding to each sub-codeblock is the same. For example, the forward check base graph matrices corresponding to sub-codeblocks such as sub-codeblock 0 (310), sub-codeblock 1 (311), and sub-codeblock 2 (312) are the same, that is, the period of the forward check base graph matrix equals 1. However, the period of the base matrix of spatially coupled LDPC coding equals 3. For example, the forward check base matrices corresponding to sub-codeblock 0 (320), sub-codeblock 1 (321), and sub-codeblock 2 (322) are different from each other. The forward check base matrices corresponding to sub-codeblocks such as sub-codeblock 0 (320) and sub-codeblock 3 (323) are the same. The forward check base matrices corresponding to sub-codeblocks such as sub-codeblock 1 (321) and sub-codeblock 4 (324) are the same. The forward check base matrices corresponding to sub-codeblocks such as sub-codeblock 2 (322) and sub-codeblock 5 (325) are the same. That is, the forward check base matrix of the t-th sub-codeblock is the same as the forward check base matrix of the (t+3)-th sub-codeblock, where t is a non-negative integer. Thus, the period of the forward check base matrix equals 3, that is, the period of the base matrix of spatially coupled LDPC coding equals 3.

In addition, as can be seen from FIG. 4, in the base matrix of spatially coupled LDPC coding in this example, the coupling width *mₛ* equals 2, the number of rows in the sub-base matrix is mb= 1, and the number of columns in the sub-base matrix is *nb*= 2. In the 0-th forward check base matrix, the corresponding 0-th sub-base matrix $H {b}_{0}^{\left(0\right)}$ is [12, 0], the 1-st sub-base matrix $H {b}_{1}^{\left(0\right)}$ is [141, 151], and the 2-nd sub-base matrix $H {b}_{2}^{\left(0\right)}$ is [10, 299]. In the 1-st forward check base matrix, the corresponding 0-th sub-base matrix $H {b}_{0}^{\left(1\right)}$ is [435, 0], the 1-st sub-base matrix $H {b}_{1}^{\left(1\right)}$ is [59, 251], and the 2-nd sub-base matrix $H {b}_{2}^{\left(1\right)}$ is [147, 262]. In the 2-nd forward check base matrix, the corresponding 0-th sub-base matrix $H {b}_{0}^{\left(2\right)}$ is [312, 0], the 1-st sub-base matrix $H {b}_{1}^{\left(2\right)}$ is [303, 123], and the 2-nd sub-base matrix $H {b}_{2}^{\left(2\right)}$ is [502, 276]. Since the base matrix of spatially coupled LDPC coding has periodic properties, the supported encoding length may be of any length. That is, the coupling chain length L may be of any length and may be determined according to the length of the to-be-encoded bit sequence or the transport block size. All '-1' elements in the base matrix of spatially coupled LDPC coding are elements indicating all-zero matrices, and all non-'-1' elements are elements indicating cyclic shifts of an identity matrix. The size (that is, the lifting size) of the all-zero matrix or identity matrix is Z, where Z equals 512. The number of bits in each sub-codeblock is that N = *nb**Z = 2*512 = 1024. The number of systematic bits in each sub-codeblock is that K = kb*Z = 1*512 = 512. The length of parity bits in each sub-codeblock is that M = N - K = 512. When no padding bits are present, the information bit length of each sub-codeblock equals the number of systematic bits of the sub-codeblock, that is, the information bit length of each sub-codeblock is less than or equal to the number of systematic bits of the sub-codeblock.

In an example, when encoding is performed using the spatially coupled LDPC code, the length of the obtained coded bit sequence equals L*N + M**mₛ*, where L is the coupling chain length, N is the number of bits in a sub-codeblock, M is the check bit length of a sub-codeblock, and *mₛ* is the coupling width. L, N, M, and *mₛ* are all positive integers. The coded bit sequence includes not only the coded bit sequences of L sub-codeblocks but also a tail bit sequence of length M**mₛ* bits.

In another example, when encoding is performed using the spatially coupled LDPC code, the length of the obtained coded bit sequence equals L*N, where L is the coupling chain length, and N is the number of bits in a sub-codeblock. Both L and N are positive integers. The coded bit sequence includes only the coded bit sequences of L sub-codeblocks. That is, no tail bits exist in the spatially coupled LDPC coding in this case.

In another example, at least one sub-base matrix in the spatially coupled LDPC code adopts one of the sub-base matrix parameters shown in FIG. 4.

In S340, the coded bit sequence or a portion of the bits in the coded bit sequence is transmitted.

In the coded bit sequence, a portion or all of the bits in each sub-codeblock are selected for transmission. A circular buffer may be used to store all bits of each sub-codeblock in advance. Bits are cyclically selected according to a predefined starting position to obtain a rate-matched bit sequence of a required specific number of bits. The rate-matched bit sequence is then transmitted.

Some examples of the data transmission method are described below.

### Example one

In this example, the number of bits in the CRC-coded sequence is determined at least by the length of a sub-codeblock information sequence of the spatially coupled LDPC coding. This example includes S1 to S4 described below.

In S1, a to-be-encoded bit sequence is determined.

The to-be-encoded bit sequence is set as *a*₀, *a*₁, *a*₂, *a*₃, . . . , *a*_{*A*-1}, and the number of bits is A.

In S2, CRC encoding is performed on the to-be-encoded bit sequence to obtain X CRC-coded sequences, where X is an integer greater than 0.

It is assumed that the number of CRC parity bits equals Lcrc, and the number of bits in a CRC-coded sequence equals B. The number B of bits in the CRC-coded sequence is determined by the length of a sub-codeblock information sequence of the spatially coupled LDPC coding. For example, the number B of bits in the CRC-coded sequence equals Y times the length of a sub-codeblock information sequence of the spatially coupled LDPC coding, that is, B equals K*Y, where Y is an integer greater than 1. In an example, Y may equal 2, 4, 6, 8, 10, 12, 16, 20, 24, 28, 32, 40, 48, 56, 64, 72, 80, 96, or 128. The length of a sub-codeblock information sequence of the spatially coupled LDPC coding is K, where K equals 512.

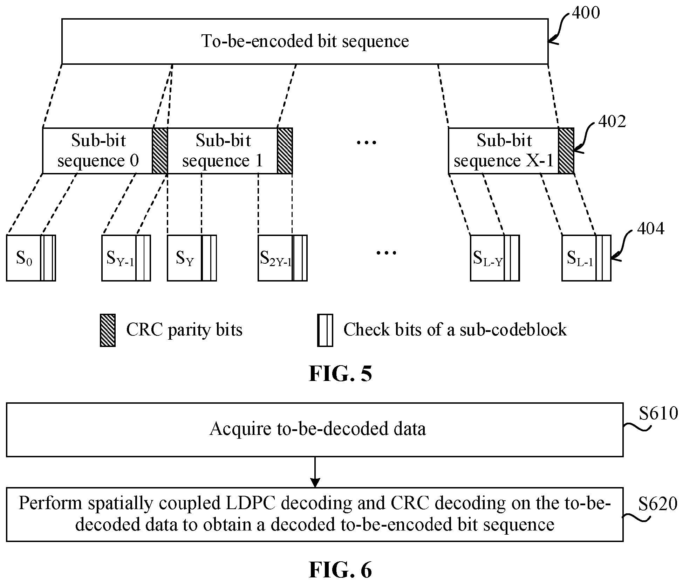

The to-be-encoded bit sequence is first segmented according to the principle that the maximum length is (B-Lcrc) to obtain X sub-bit sequences. The maximum length of each sub-bit sequence is (B-Lcrc). CRC encoding is then performed on each of the X sub-bit sequences to obtain X CRC-coded sequences. FIG. 5 is a diagram illustrating the configuration of a coded bit sequence according to an embodiment of the present application. As shown in the example of data flow change in FIG. 5, the to-be-encoded bit sequence 400 is segmented into X sub-bit sequences. The obtained sub-bit sequences after segmentation correspond to information sequences of the CRC encoding. Each sub-bit sequence undergoes CRC encoding to obtain a CRC parity bit sequence with a bit length equal to Lcrc. The CRC parity bit sequence is combined with the sub-bit sequence to obtain a CRC-coded sequence 402. In FIG. 5, the hatched portion in the CRC-coded sequence 402 represents the CRC parity bits.

In S3, spatially coupled LDPC encoding is performed on the X CRC-coded sequences to obtain a coded bit sequence. In this example, the base matrix of spatially coupled LDPC coding shown in FIG. 4 is used for encoding to obtain the coded bit sequence. As shown in FIG. 5, each CRC-coded sequence is further segmented into Y sub-codeblock information sequences. That is, *S*₀, *S*₁, ··· , *S*_{*Y-*1}. After division of all CRC-coded sequences, L sub-codeblock information sequences *S*₀, *S*₁, ··· , *S*_{*L*-1} can be obtained. Spatially coupled LDPC coding is performed on the L sub-codeblock information sequences *S*₀, *S*₁, ··· , *S_{L}*-1 to obtain parity bits of each sub-codeblock (the vertically shaded portions in FIG. 5). The information sequence of each sub-codeblock is combined with corresponding parity bits to obtain a coded bit sequence 404.

In S4, the coded bit sequence or a portion of the bits in the coded bit sequence is transmitted.

In the coded bit sequence 404, a portion or all of the bits in each sub-codeblock are selected for transmission. A circular buffer may be used to store all bits of each sub-codeblock in advance. Bits are cyclically selected according to a predefined starting position to obtain a rate-matched bit sequence of a required specific number of bits. The rate-matched bit sequence is then transmitted.

In this example, the number of bits B in a CRC-coded sequence is determined by the length K of a sub-codeblock information sequence of the spatially coupled LDPC coding according to the following calculation formula: *B* = *K* · *Y*. Y is an integer greater than 1.

In an example, the information sequence length K of each sub-codeblock of the spatially coupled LDPC coding is set to 512 bits, and Y equals 16. Then, the number of bits B in a CRC-coded sequence equals 8192. In addition, it is assumed that the to-be-encoded bit sequence is *a*₀, *a*₁, *a*₂, *a*₃, . . . , *a*_{*A*-1}, the number of bits A equals 40840, and the number Lcrc of parity bits obtained by CRC encoding equals 24. CRC encoding is performed using the generator polynomial *g*_{CRC24A}(*D*) described above. The to-be-encoded bit sequence of length 40840 is first segmented according to the principle that the maximum length is B - Lcrc = 8168 (the maximum number of bits of an information sequence of CRC encoding equals 8168) to obtain X=5 sub-bit sequences. That is, the maximum length of each sub-bit sequence is 8168. CRC encoding is then performed on each of the X=5 sub-bit sequences to obtain CRC-coded sequences each having a length of 8192 bits.

Spatially coupled LDPC encoding is performed on the 5 CRC-coded sequences to obtain a coded bit sequence with 82944 bits. The coded bit sequence includes 80 sub-codeblocks and a tail check sequence. The number of bits in each sub-codeblock equals 1024. The number of bits in the information sequence of each sub-codeblock equals 512 bits (that is, no padding bits). The number of bits in the tail check sequence equals 1024. The 0-th CRC-coded sequence corresponds to information sequences of consecutive 0-th to 15-th sub-codeblocks. The 1-st CRC-coded sequence corresponds to information sequences of consecutive 16-th to 31-st sub-codeblocks. The 2-nd CRC-coded sequence corresponds to information sequences of consecutive 32-nd to 47-th sub-codeblocks. The 3-rd CRC-coded sequence corresponds to information sequences of consecutive 48-th to 63-rd sub-codeblocks. The 4-th CRC-coded sequence corresponds to information sequences of consecutive 64-th to 79-th sub-codeblocks. The coded bit sequence or a portion of the bits in the coded bit sequence is transmitted to a second transmission node.

### Example two

This example differs from example one in that the number of bits in the CRC-coded sequence in this example is determined at least by the transport block size. The transport block size is denoted as TBS. For example, the number B of bits in a CRC-coded sequence is determined from the TBS according to the following formula: *B* = *TBS* + *L_{crc}*.

Lcrc is the number of CRC parity bits and is an integer greater than 1. In an example, when the TBS is less than a first threshold, the formula that *B* = *TBS* + *L_{crc}* is directly used to calculate the number B of bits in the CRC-coded sequence. The first threshold is an integer greater than or equal to 1024 and less than or equal to 40960. In an example, the first threshold may equal one of the following: 1024, 2048, 4096, 6144, 8192, 8448, 16384, 20480, or 32768. In another example, the first threshold may be determined by the number of CRC parity bits. For example, when the number of CRC parity bits is 16, the first threshold equals 8192 or 4096. When the number of CRC parity bits is 24, the first threshold equals 16384 or 32768.

In an example, the transport block size is set to 2544, the information sequence length K of each sub-codeblock of the spatially coupled LDPC coding is 512 bits (that is, no padding bits), and the number Lcrc of CRC parity bits equals 16. Then, the number B of bits in the CRC-coded sequence equals the sum of the transport block size and Lcrc, that is, B = 2544 + 16 = 2560. In this case, the to-be-encoded bit sequence is *a*₀, *a*₁, *a*₂, *a*₃, . . . , *a*_{*A*-1}, where A equals 2544, which means that no transport block-level CRC has been added. CRC encoding is performed on the to-be-encoded bit sequence. The number Lcrc of obtained CRC parity bits equals 16. CRC encoding is performed using the generator polynomial *g*_{CRC16}(*D*) described above to obtain one CRC-coded sequence with a length of 2560 bits.

Spatially coupled LDPC encoding is performed on the one CRC-coded sequence to obtain a coded bit sequence including 5 sub-codeblocks. The number of bits in each sub-codeblock equals 1024, and the length of the information sequence in each sub-codeblock equals 512 bits. The CRC-coded sequence with a length of 2560 bits corresponds to information sequences of consecutive 0-th to the 4-th sub-codeblocks. The coded bit sequence or a portion of the bits in the coded bit sequence is transmitted to a second transmission node.

### Example three

This example differs from example one in that the number of bits in the CRC-coded sequence in this example is determined by the following parameters: the length of a sub-codeblock information sequence of the spatially coupled LDPC coding and the length of the to-be-encoded bit sequence. The number of systematic bits of a sub-codeblock of the spatially coupled LDPC coding is set to K, and the length of the to-be-encoded bit sequence is set to A. The number X of CRC-coded sequences is first determined from the length A of the to-be-encoded bit sequence according to the following formula: $X = \left⌈\frac{A}{{K}_{max}}\right⌉ .$

*Kₘₐₓ* is the maximum number of bits of an information sequence of CRC encoding, and *Kₘₐₓ* may equal (but is not limited to) at least one of the following: 6120, 6144, 8168, 8192, 8424, 8448, or 16384. The calculation formula $\left⌈x\right⌉$ represents taking the smallest integer greater than or equal to the real number *x*.

The number L of sub-codeblocks (that is, the coupling chain length) in the spatially coupled LDPC coding is then determined according to X, K, and A using the following formula: $L = \left⌈\frac{A + X ⋅ {L}_{crc}}{K}\right⌉ .$

The calculation formula $\left⌈x\right⌉$ represents taking the smallest integer greater than or equal to x. Next, the length of the information sequence of each of the L sub-codeblocks in the spatially coupled LDPC coding is determined according to K and A as follows: (1) The length of the information sequence of the 0-th to (H-1)-th sub-codeblocks is $\left⌈\left(A+X⋅{L}_{crc}\right)/L\right⌉$. (2) The length of the information sequence of the H-th to (L-1)-th sub-codeblocks is $\left⌊\left(A+X⋅{L}_{crc}\right)/L\right⌋$, where *H* = *mod*(*A* + *X · L_{crc}*, *L*). *mod*(*x*1, *x*2) represents the remainder obtained when the integer x1 is divided by the integer x2. It can be seen that the length of a sub-codeblock information sequence of the spatially coupled LDPC coding may be determined by at least one of the following parameters: the number of systematic bits of a sub-codeblock of the spatially coupled LDPC coding, the maximum number of bits of an information sequence of CRC encoding, and the length of the to-be-encoded bit sequence.

Furthermore, the number of bits in a CRC-coded sequence is determined according to at least one of the following:
1. The number of bits in the i-th CRC-coded sequence equals the sum of the lengths of the information sequences of the *i* · *Y*-th to (*i* + 1) · *Y* - 1-th sub-codeblocks, where Y is an integer greater than 1. In an example, Y may be determined by the following parameters: the number of sub-codeblocks of the spatially coupled LDPC coding and the number X of CRC-coded sequences. In an example, $Y = \left⌊L/X\right⌋$*.* Here, i is a non-negative integer less than X or a non-negative integer less than X-1.
2. The number of bits in the last CRC-coded sequence equals the sum of the lengths of the information sequences of the (*X* - 1) · *Y*-th to the last sub-codeblocks, where Y is an integer greater than 1.
3. The number of bits in the first G CRC-coded sequences all equal the sum of the lengths of the information sequences of consecutive $\left⌈L/X\right⌉$ sub-codeblocks, and the number of bits in the last (X-G) CRC-coded sequences all equal the sum of the lengths of the information sequences of consecutive $\left⌊L/X\right⌋$ sub-codeblocks. Here, *G* = *mod*(*L, X*).

In an example, it is assumed that the length of the to-be-encoded bit sequence is 120000, the number K of systematic bits of each sub-codeblock of the spatially coupled LDPC coding is 512 bits, the number Lcrc of CRC parity bits equals 24, and the maximum number *Kₘₐₓ* of bits of an information sequence of CRC encoding equals 8424. In this case, the to-be-encoded bit sequence is *a*₀, *a*₁, *a*₂, *a*₃, . . . *, a*_{*A*-1}*,* where A equals 120000. It can be known that the number of CRC-coded sequences is $X = \left⌈A/{K}_{max}\right⌉ = 15$.

The number L of sub-codeblocks (that is, the coupling chain length) in the spatially coupled LDPC coding is then determined according to X, K, and A, where $L = \left⌈\left(A+X⋅{L}_{crc}\right)/K\right⌉ = 236$ . Furthermore, (1) the length of the information sequence of the 0-th to (H-1)-th sub-codeblocks is 510 (corresponding to the number of padding bits equal to 2); (2) the length of the information sequence of the H-th to (L-1)-th sub-codeblocks is 510 (corresponding to the number of padding bits equal to 2), where *H* = *mod*(*A + X* · *L_{crc}, L*) = 0, that is, the length of the information sequence of all sub-codeblocks equals 510.

In an example, the number of bits in the CRC-coded sequences is as follows: The number of bits in the i-th CRC-coded sequence equals the sum of the lengths of the information sequences of the *i* · *Y*-th to (*i +* 1) · *Y* - 1-th sub-codeblocks, where Y is an integer greater than 1. The parameter Y is determined by the number L of sub-codeblocks of the spatially coupled LDPC coding and the number X of CRC-coded sequences, that is, $Y = \left⌊L/X\right⌋ = 15$. Here, i = 0, 1, 2, 3, ..., 13. That is, the number of bits in the 0-th to 13-th CRC-coded sequences all equal (15*510=) 7650. The number of bits in the last CRC-coded sequence equals the sum of the lengths of the information sequences of the (*X* - 1) · *Y*-th to the last sub-codeblocks, where Y is an integer greater than 1. That is, the number of bits in the last (14-th) CRC-coded sequence equals (L-(X-1)*Y)*510=) 13260.

In another example, the number of bits in the CRC-coded sequences is as follows: The number of bits in the first G CRC-coded sequences all equal the sum of the lengths of the information sequences of consecutive $\left⌈L/X\right⌉ = 16$ sub-codeblocks, and the number of bits in the last (X-G) CRC-coded sequences all equal the sum of the lengths of the information sequences of consecutive $\left⌊L/X\right⌋ = 15$ sub-codeblocks. Here, *G* = *mod*(*L, X*) = 11. That is, the number of bits in the i-th CRC-coded sequence equals the sum of the lengths of the information sequences of the *i* · 16-th to (*i* + 1) *·* 16 - 1-th sub-codeblocks, that is, the number of bits in the i-th CRC-coded sequence is 16*510 = 8160, where i = 0, 1, 2, 3, ..., 10. In addition, the number of bits in the j-th CRC-coded sequence equals the sum of the lengths of the information sequences of the 11 · 16 + (*j -* 11) *·* 15-th to 11 · 16 + (*j* - 10) *·* 15 - 1-th sub-codeblocks, that is, the number of bits in the j-th CRC-coded sequence is 15*510 = 7650, where j = 11, 12, 13, 14.

CRC encoding is performed on the to-be-encoded bit sequence. The number Lcrc of CRC parity bits equals 24. CRC encoding is performed using the generator polynomial *g*_{CRC24B}(*D*) described above to obtain CRC-coded sequences. According to the calculated number of bits of the 0-th to 14-th CRC-coded sequences, it is assumed that the number of bits corresponds to Bi, where i = 0, 1, 2, 3, ..., 14. When i is less than 11, Bi equals 8160. When i is greater than or equal to 11, Bi equals 7650. The to-be-encoded bit sequence is then segmented to obtain X=15 sub-bit sequences. The length of the i-th sub-bit sequence is Bi-Lcrc. That is, when i is less than 11, the length of the i-th sub-bit sequence equals (8160-24=) 8136. When i is greater than or equal to 11, the length of the i-th sub-bit sequence equals (7650-24=) 7626. CRC encoding is then performed on each of the X=15 sub-bit sequences to obtain 15 CRC-coded sequences.

Spatially coupled LDPC encoding is performed on the 15 CRC-coded sequences (with a total length of 120360 bits) to obtain a coded bit sequence including 236 sub-codeblocks, where the length of the information sequence of each sub-codeblock equals 510 bits. The coded bit sequence or a portion of the bits in the coded bit sequence is transmitted to a second transmission node.

### Example four

This example differs from example one in that the number of bits in the CRC-coded sequence in this example is determined by the following parameters: the length of a sub-codeblock information sequence of the spatially coupled LDPC coding, the number of systematic bits of a sub-codeblock of the spatially coupled LDPC coding, the number of sub-codeblocks of the spatially coupled LDPC coding, and the maximum number of CRC-coded sequences. The length of a sub-codeblock information sequence of the spatially coupled LDPC coding is set to K, the number of sub-codeblocks of the spatially coupled LDPC coding is set to L (that is, the coupling chain length is L), and the number of CRC parity bits is set to Lcrc.

In an example, the number of bits in at least one CRC-coded sequence among the X CRC-coded sequences is determined by the following formula: $\left⌈\frac{L}{{X}_{max}}\right⌉ ⋅ K , or \left⌊\frac{L}{{X}_{max}}\right⌋ ⋅ K .$

In the formula, *Xₘₐₓ* is the maximum number of CRC-coded sequences, and *Xₘₐₓ* is a positive integer; the calculation formula $\left⌈x\right⌉$ represents taking the smallest integer greater than or equal to *x*, and the calculation formula $\left⌊x\right⌋$ represents taking the largest integer less than or equal to x. In an example, *Xₘₐₓ* may equal (but is not limited to) at least one of the following: 4, 6, 8, 10, 12, 16, 18, 20, 24, 32, 48, or 64.

In an example, the length of a sub-codeblock information sequence of the spatially coupled LDPC coding is K = 1024, and the number of sub-codeblocks of the spatially coupled LDPC coding is L = 200. In addition, the maximum number *Xₘₐₓ* of CRC-coded sequences is taken as 20. Then, the number of bits in each CRC-coded sequence is $\left⌊L/{X}_{max}\right⌋ ⋅ K = 10240$, and the number of CRC-coded sequences is X = 20. Each CRC-coded sequence includes 10 sub-codeblock information sequences used in the spatially coupled LDPC coding. In this example, the to-be-encoded bit sequence is *a*₀, *a*₁, *a*₂, *a*₃, . . . , *a*_{*A*-1}, where A equals 204320.

In this example, in the spatially coupled LDPC coding base matrix, the coupling width *mₛ* equals 2, and the period of the base matrix equals 3. In the spatially coupled LDPC coding, the lifting size Z equals 1024, the coupling width *mₛ* equals 2, the number of rows in each sub-base matrix is mb = 1, and the number of columns in each sub-base matrix is nb = 2. In addition, in the 0-th forward check base matrix, the corresponding 0-th sub-base matrix $H {b}_{0}^{\left(0\right)}$ is [227, 0], the 1-st sub-base matrix $H {b}_{1}^{\left(0\right)}$ is [286, 1009], and the 2-nd sub-base matrix $H {b}_{2}^{\left(0\right)}$ is [88, 939]. In the 1-st forward check base matrix, the corresponding 0-th sub-base matrix $H {b}_{0}^{\left(1\right)}$ is [985, 0], the 1-st sub-base matrix $H {b}_{1}^{\left(1\right)}$ is [630, 973], and the 2-nd sub-base matrix $H {b}_{2}^{\left(1\right)}$ is [599, 1020]. In the 2-nd forward check base matrix, the corresponding 0-th sub-base matrix $H {b}_{0}^{\left(2\right)}$ is [796, 0], the 1-st sub-base matrix $H {b}_{1}^{\left(2\right)}$ is [355, 390], and the 2-nd sub-base matrix $H {b}_{2}^{\left(2\right)}$ is [352, 303]. The number of bits in each sub-codeblock equals N=nb*Z=2*1024=2048. The number of systematic bits of each sub-codeblock of the spatially coupled LDPC coding equals K=kb*Z=1*1024=1024. The length of parity bits in each sub-codeblock equals M=N-K=1024. The number of bits in the tail check sequence equals Ms*M=2048.

CRC encoding is performed on the to-be-encoded bit sequence to obtain X=20CRC-coded sequences. The to-be-encoded bit sequence is first segmented into 20 sub-bit sequences, and each sub-bit sequence has a length of 10216. CRC encoding is then performed on each sub-bit sequence to obtain CRC-coded sequences each having a length of 10240 bits. The number Lcrc of CRC parity bits in each CRC-coded sequence equals 24. CRC encoding is performed using the generator polynomial *g*_{CRC24C}(*D*) described above. Spatially coupled LDPC coding is performed on the X=20 CRC-coded sequences to obtain a coded bit sequence. The i-th CRC-coded sequence corresponds to sub-codeblock indices i*10 to (i+1)*10-1 in the spatially coupled LDPC coding, where i = 0, 1, 2, 3, ..., 19. That is, the 0-th CRC-coded sequence is placed in the information sequences of the 0-th to 9-th consecutive sub-codeblocks (that is, *S*₀, *S*₁, ··· *, S*₉), the 1-st CRC-coded sequence is placed in the information sequences of the 10-th to 19-th consecutive sub-codeblocks (that is, *S*₁₀, *S*₁₁, ··· *, S*₁₉ ), the 2-nd CRC-coded sequence is placed in the information sequences of the 20-th to 29-th consecutive sub-codeblocks (that is, *S*₂₀, *S*₂₁, ··· *, S*₂₉), and so on. In this case, no padding bits exist in the spatially coupled LDPC coding, and the length of the information sequence of each sub-codeblock equals the number of systematic bits of the sub-codeblock. Spatially coupled LDPC encoding is performed on the information sequences of the L=200 sub-codeblocks (that is, *S*₀, *S*₁, ··· *, S*₁₉₉) to obtain a coded bit sequence containing L=200 sub-codeblocks and a tail check sequence. The number of bits in each sub-codeblock equals 2048, and the number of bits in the tail check sequence equals 2048.

Finally, the coded bit sequence obtained after the spatially coupled LDPC coding or a portion of the bits in the coded bit sequence is transmitted. In the coded bit sequence, a portion or all of the bits in each sub-codeblock are selected for transmission. A circular buffer may be used to store all bits of each sub-codeblock in advance. Bits are cyclically selected according to a predefined starting position to obtain a rate-matched bit sequence of a required specific number of bits. The rate-matched bit sequence is then transmitted.

### Example five

This example differs from example one in that the number of bits in the CRC-coded sequence in this example is determined by the following parameters: the length of a sub-codeblock information sequence of the spatially coupled LDPC coding and the period of a base graph matrix of the spatially coupled LDPC coding. The length of a sub-codeblock information sequence of the spatially coupled LDPC coding is set to K, and the period of the base graph matrix of the spatially coupled LDPC coding is set to T0. In an example, the number of bits in the CRC-coded sequence equals a positive integer multiple of K, T0, or K*T0. Specifically, the number of bits in the CRC-coded sequence equals Y times K*T0, where Y may equal 4, 6, 8, 10, 12, 16, 20, 24, 32, or 48. Both K and T0 are integers greater than 0.

In an example, the number of bits in the CRC-coded sequence is determined by the following formula: *K* · *T*0 · *Y*, where Y is a positive integer. In an example, the spatially coupled LDPC coding method is used, in which the period T0 of the base graph matrix equals 2 and the length K of the information sequence of each sub-codeblock is 400 bits. The value of Y is 8. Then, the number of bits in the CRC-coded sequence is 6400. The to-be-encoded bit sequence is set to *a*₀, *a*₁, *a*₂, *a*₃, . . . *, a*_{*A-*1}, where A equals 127520.

CRC encoding is performed on the to-be-encoded bit sequence to obtain X=20 CRC-coded sequences. The to-be-encoded bit sequence is first segmented into 20 sub-bit sequences, and each sub-bit sequence has a length of 6376. CRC encoding is then performed on each sub-bit sequence to obtain CRC-coded sequences each having a length of 6400 bits. The number Lcrc of CRC parity bits obtained by CRC encoding equals 24. CRC encoding is performed using the generator polynomial *g*_{CRC24A}(*D*) described above. Spatially coupled LDPC coding is performed on the X=20 CRC-coded sequences to obtain a coded bit sequence. Each CRC-coded sequence is mapped to information sequences of 16 consecutive sub-codeblocks of the spatially coupled LDPC coding. The i-th CRC-coded sequence corresponds to sub-codeblock indices i*16 to (i+1)*16-1 in the spatially coupled LDPC coding, where i = 0, 1, 2, 3, ..., 19.

In this example, in the spatially coupled LDPC coding base matrix, the coupling width *mₛ* equals 2, the period of the base graph matrix of the spatially coupled LDPC coding equals 3, the lifting size Z equals 400, the number of rows in the sub-base matrix is mb = 1, and the number of columns in the sub-base matrix is nb = 2. The number of bits in each sub-codeblock equals N=nb*Z=2*400=800. The information bit length of each sub-codeblock in the spatially coupled LDPC code equals K=kb*Z=1*400=400. The length of parity bits of each sub-codeblock in the spatially coupled LDPC code equals M=N-K=400. The number of bits in the tail check sequence in the spatially coupled LDPC code equals Ms*M=800.

Finally, the coded bit sequence obtained after the spatially coupled LDPC coding or a portion of the bits in the coded bit sequence is transmitted. In the coded bit sequence, a portion or all of the bits in each sub-codeblock are selected for transmission. A circular buffer may be used to store all bits of each sub-codeblock in advance. Bits are cyclically selected according to a predefined starting position to obtain a rate-matched bit sequence of a required specific number of bits. The rate-matched bit sequence is then transmitted.

### Example six

This example differs from example one in that the number of bits in the CRC-coded sequence in this example is determined by the following parameters: the length of a sub-codeblock information sequence of the spatially coupled LDPC coding and the period of a base matrix of the spatially coupled LDPC coding. The length of a sub-codeblock information sequence of the spatially coupled LDPC coding is set to K, and the period of the base matrix of the spatially coupled LDPC coding is set to T1. In an example, the number of bits in the CRC-coded sequence equals a positive integer multiple of K, T1, or K*T1. Specifically, the number of bits in the CRC-coded sequence equals Y times K*T1, where Y may equal 4, 6, 8, 10, 12, 16, 20, 24, 32, or 48. Both K and T1 are integers greater than 0.

In an example, the number of bits in the CRC-coded sequence is determined by the following formula: *K* · *T*1 · *Y*, where Y is a positive integer. In an example, the spatially coupled LDPC coding method is used, in which the period T1 of the base graph matrix equals 3 and the length K of the information sequence of each sub-codeblock is 600 bits. The value of Y is 6. Then, the number of bits in the CRC-coded sequence is 10800. The to-be-encoded bit sequence is set to *a*₀, *a*₁, *a*₂, *a*₃, . . . *, a*_{*A-*1}, where A equals 1077600.

CRC encoding is performed on the to-be-encoded bit sequence to obtain X=100 CRC-coded sequences. The to-be-encoded bit sequence is first segmented into 100 sub-bit sequences, and each sub-bit sequence has a length of 10776. CRC encoding is then performed on each sub-bit sequence to obtain CRC-coded sequences each having a length of 10800 bits. The number Lcrc of CRC parity bits equals 24. CRC encoding is performed using the generator polynomial *g*_{CRC24A}(*D*) described above. Spatially coupled LDPC coding is performed on the X=100 CRC-coded sequences to obtain a coded bit sequence. Each CRC-coded sequence is mapped to information sequences of 18 sub-codeblocks of the spatially coupled LDPC coding. The i-th CRC-coded sequence corresponds to sub-codeblock indices i*18 to (i+1)*18-1 in the spatially coupled LDPC coding, where i = 0, 1, 2, 3, ..., 99.

In this example, in the spatially coupled LDPC coding base matrix, the coupling width *mₛ* equals 2, the period of the base matrix of the spatially coupled LDPC coding equals 3, the lifting size Z equals 600, the number of rows in the sub-base matrix is mb = 1, and the number of columns in the sub-base matrix is nb = 2. In addition, in the 0-th forward check base matrix, the corresponding 0-th sub-base matrix $H {b}_{0}^{\left(0\right)}$ is [327, 0], the 1-st sub-base matrix $H {b}_{1}^{\left(0\right)}$ is [392, 32], and the 2-nd sub-base matrix $H {b}_{2}^{\left(0\right)}$ is [110, 268]. In the 1-st forward check base matrix, the corresponding 0-th sub-base matrix $H {b}_{0}^{\left(1\right)}$ is [486, 0], the 1-st sub-base matrix $H {b}_{1}^{\left(1\right)}$ is [389, 57], and the 2-nd sub-base matrix $H {b}_{2}^{\left(1\right)}$ is [16, 20]. In the 2-nd forward check base matrix, the corresponding 0-th sub-base matrix $H {b}_{0}^{\left(2\right)}$ is [411, 0], the 1-st sub-base matrix $H {b}_{1}^{\left(2\right)}$ is [276, 97], and the 2-nd sub-base matrix $H {b}_{2}^{\left(2\right)}$ is [404, 543]. The number of bits in each sub-codeblock equals N= nb*Z=2*600=1200. The number of systematic bits of each sub-codeblock equals K=kb*Z=1*600=600. The length of parity bits of each sub-codeblock equals M=N-K=600. The number of bits in the tail check sequence equals Ms*M=1200. In this example, no padding bits exist, and the information bit length equals the number of systematic bits.

Finally, the coded bit sequence obtained after the spatially coupled LDPC coding or a portion of the bits in the coded bit sequence is transmitted. In the coded bit sequence, a portion or all of the bits in each sub-codeblock are selected for transmission. A circular buffer may be used to store all bits of each sub-codeblock in advance. Bits are cyclically selected according to a predefined starting position to obtain a rate-matched bit sequence of a required specific number of bits. The rate-matched bit sequence is then transmitted.

### Example seven

This example differs from example one in that the number of bits in the CRC-coded sequence in this example is determined by the following parameters: the number of systematic bits of a sub-codeblock of the spatially coupled LDPC coding, the length of the to-be-encoded bit sequence, the maximum number of bits of a CRC-coded sequence, and the number of CRC parity bits. The number of systematic bits of a sub-codeblock of the spatially coupled LDPC coding is set to K, the length of the to-be-encoded bit sequence is set to A, the maximum number of bits of a CRC-coded sequence is set to C, and the number of CRC parity bits is set to Lcrc. In an example, the maximum number C of bits of the CRC-coded sequence includes at least one of the following: 4096, 6144, 8192, 8448, or 16384.

In an example, the number of CRC-coded sequences is determined by the following formula: $X = \left⌈A/\left(C-Lcrc\right)\right⌉$.

The number of sub-codeblocks of the spatially coupled LDPC coding is determined by the following formula: $L = \left⌈\left(A+X\times Lcrc\right)/K\right⌉$*.*

The length of the information sequence of each of the L sub-codeblocks in the spatially coupled LDPC coding is determined as follows: (1) The length of the information sequence of the 0-th to (H-1)-th sub-codeblocks is $\left⌈\left(A+X⋅{L}_{crc}\right)/L\right⌉$*.* (2) The length of the information sequence of the H-th to (L-1)-th sub-codeblocks is $\left⌊\left(A+X⋅{L}_{crc}\right)/L\right⌋$*.* Here, *H* = *mod*(*A + X* · *L_{crc}*, *L*).

The number of bits in the CRC-coded sequences is determined as follows: The number of bits in the first G CRC-coded sequences all equal the sum of the lengths of the information sequences of consecutive $\left⌈L/X\right⌉$ sub-codeblocks, and the number of bits in the last (X-G) CRC-coded sequences all equal the sum of the lengths of the information sequences of consecutive $\left⌊L/X\right⌋$ sub-codeblocks. Here, *G* = *mod*(*L, X*).

In a specific example, the number of systematic bits of a sub-codeblock of the spatially coupled LDPC coding is set to K=1024, the length of the to-be-encoded bit sequence is set to A=2000000, the maximum number of bits of a CRC-coded sequence is set to C=8192, and the number of CRC parity bits is set to Lcrc=24. In this case, the to-be-encoded bit sequence is *a*₀, *a*₁, *a*₂, *a*₃, . . . *, a*_{*A*-1}*,* where A equals 2000000. It can be known that the number of CRC-coded sequences is $X = \left⌈A/\left(C-Lcrc\right)\right⌉ = 245$.

The number of sub-codeblocks of the spatially coupled LDPC coding is L = $\left⌈\left(A+X\times Lcrc\right)/K\right⌉ = 1959$.

The length of the information sequence of the L=1959 sub-codeblocks in the spatially coupled LDPC coding is as follows: (1) The length of the information sequence of the 0-th to (H-1) (=1822)-th sub-codeblocks is $\left⌈\left(A+X⋅{L}_{crc}\right)/L\right⌉ = 1024$. (2) The length of the information sequence of the H (=1823)-th to (L-1) (=1958)-th sub-codeblocks is $\left⌊\left(A+X⋅{L}_{crc}\right)/L\right⌋ = 1023$. Here, *H* = *mod*(*A + X · L_{crc}, L*) = 1823.

The number of bits in the CRC-coded sequences is as follows: The number of bits in the first G (=244) CRC-coded sequences all equal the sum of the lengths of the information sequences of consecutive $\left⌈L/X\right⌉ = 8$ sub-codeblocks, and the number of bits in the last X-G (=1) CRC-coded sequence equals the sum of the lengths of the information sequences of consecutive $\left⌊L/X\right⌋ = 7$ sub-codeblocks. Here, *G* = *mod*(*L*, *X*) = 244. That is, the number of bits in each CRC-coded sequence is as follows: The number of bits in the 0-th to 226-th CRC-coded sequences equals 8192, the number of bits in the 227-th CRC-coded sequence equals 8191, the number of bits in the 228-th to 243-rd CRC-coded sequences equals 8184, and the number of bits in the 244-th CRC-coded sequence equals 7161. Correspondingly, the number of information bits in each CRC-coded sequence equals the number of bits in each CRC-coded sequence minus the number Lcrc of CRC parity bits. That is, the number of information bits in the 0-th to 226-th CRC-coded sequences equals 8192-24=8168, the number of information bits in the 227-th CRC-coded sequence equals 8191-24=8167, the number of information bits in the 228-th to 243-rd CRC-coded sequences equals 8184-24=8160, and the number of information bits in the 244-th CRC-coded sequence equals 7161-24=7137.

The to-be-encoded bit sequence is segmented according to the information bit numbers of each CRC-coded sequence described above to obtain 245 sub-sequences. CRC encoding is then performed on each sub-sequence according to the number Lcrc=24 of CRC parity bits to obtain 245 CRC-coded sequences. Next, spatially coupled LDPC coding is performed on the 245 CRC-coded sequences to obtain a coded bit sequence including 1959 sub-codeblocks.

Finally, the coded bit sequence obtained after the spatially coupled LDPC encoding or a portion of the bits in the coded bit sequence is transmitted. In the coded bit sequence, a portion or all of the bits in each sub-codeblock are selected for transmission. A circular buffer may be used to store all bits of each sub-codeblock in advance. Bits are cyclically selected according to a predefined starting position to obtain a rate-matched bit sequence of a required specific number of bits. The rate-matched bit sequence is then transmitted.

### Example eight

In this example, the number of systematic bits of a sub-codeblock of the spatially coupled LDPC coding is set to K, the length of the to-be-encoded bit sequence is set to A, the maximum number of bits of a CRC-coded sequence is set to C, and the number of CRC parity bits is set to Lcrc. The number of bits in a CRC-coded sequence is greater than or equal to H times the length of a sub-codeblock information sequence of the spatially coupled LDPC coding, where H equals at least one of the following: 2, 3, 4, 5, 6, 7, 8, 10, 12, 14, 16, 20, 24, or 32.

First, the to-be-encoded bit sequence is segmented and subjected to CRC encoding to obtain multiple CRC-coded sequences. The number of CRC-coded sequences and the number of information bits in the CRC-coded sequences are determined as follows:
1. The number of CRC-coded sequences is determined by the following formula: $X = \left⌈A/\left(C-Lcrc\right)\right⌉$ *.* Here, X is an integer greater than or equal to 1.
2. The number of information bits of CRC encoding is determined. The number of bits in the first G CRC-coded sequences all equal $\left⌈A/X\right⌉$*,* and the number of bits in the last X-G CRC-coded sequences all equal $\left⌊A/X\right⌋$*.* Here, *G* = *mod*(*A, X*). The number of information bits of CRC encoding in each CRC-coded sequence can be obtained by subtracting the number Lcrc of CRC parity bits from the number of bits in each CRC-coded sequence. Here, $\left⌈A/X\right⌉$ is greater than 1, and/or $\left⌊A/X\right⌋$ is greater than 1.

Next, spatially coupled LDPC encoding is performed on the multiple CRC-coded sequences to obtain a coded bit sequence. The number of sub-codeblocks and the length of the information sequence of the sub-codeblock in the spatially coupled LDPC coding are determined as follows:

The number of sub-codeblocks of the spatially coupled LDPC coding is determined by the following formula: $L = \left⌈\left(A+X\times Lcrc\right)/K\right⌉$*.*

The length of the information sequence of each of the L sub-codeblocks in the spatially coupled LDPC coding is determined as follows: (1) The length of the information sequence of the 0-th to (H-1)-th sub-codeblocks is $\left⌈\left(A+X⋅{L}_{crc}\right)/L\right⌉$*.* (2) The length of the information sequence of the H-th to (L-1)-th sub-codeblocks is $\left⌊\left(A+X⋅{L}_{crc}\right)/L\right⌋$*.* Here, *H* = *mod*(*A + X* · *L_{crc}*, *L*). In an example, the minimum value of L equals one of the following: 4, 6, 8, 10, 12, 16, 24, or 32.

In a specific example, the number of systematic bits of a sub-codeblock of the spatially coupled LDPC coding is set to K=2048, the length of the to-be-encoded bit sequence is set to A=100000, the maximum number of bits of a CRC-coded sequence is set to C=6000, and the number of CRC parity bits is set to Lcrc=16. The to-be-encoded bit sequence is segmented and subjected to CRC encoding to obtain multiple CRC-coded sequences. The number of CRC-coded sequences and the number of information bits in the CRC-coded sequences are determined as follows:
1. The number of CRC-coded sequences is $X = \left⌈A/\left(C-Lcrc\right)\right⌉ = 17$.
2. The number of bits in the first G=6 CRC-coded sequences all equal $\left⌈A/X\right⌉ = 5883$, and the number of bits in the last X-G=11 CRC-coded sequences all equal $\left⌊A/X\right⌋ = 5882$. Here, *G = mod(A, X) = 6.*

Next, spatially coupled LDPC encoding is performed on the 17 CRC-coded sequences to obtain a coded bit sequence. The number of sub-codeblocks and the length of the information sequence of the sub-codeblock in the spatially coupled LDPC coding are determined as follows:

The number of sub-codeblocks of the spatially coupled LDPC coding is L = $\left⌈\left(A+X\times Lcrc\right)/K\right⌉ = 49$.

The length of the information sequence of the L=49 sub-codeblocks in the spatially coupled LDPC coding is as follows: (1) The length of the information sequence of the 0-th to (H-1=17)-th sub-codeblocks is $\left⌈\left(A+X⋅{L}_{crc}\right)/L\right⌉ = 2047$. (2) The length of the information sequence of the H=18-th to (L-1=48)-th sub-codeblocks is $\left⌊\left(A+X⋅{L}_{crc}\right)/L\right⌋ = 2046$. Here, *H* = *mod*(*A + X* · *L_{crc}*, *L*) = 18. That is, the number of bits in the CRC-coded sequence is greater than the length of a sub-codeblock information sequence of the spatially coupled LDPC coding by H times, where H equals 2.

In another specific example, the calculated length of a sub-codeblock information sequence of the spatially coupled LDPC coding is K = 512, and the number of bits in the CRC-coded sequence is C = 8448. That is, the number of bits in the CRC-coded sequence is greater than the length of a sub-codeblock information sequence of the spatially coupled LDPC coding by H times, where H equals 16.

In another specific example, the calculated length of a sub-codeblock information sequence of the spatially coupled LDPC coding is K = 512, and the number of bits in the CRC-coded sequence is C = 4096. That is, the number of bits in the CRC-coded sequence equals the length of a sub-codeblock information sequence of the spatially coupled LDPC coding by H times, where H equals 8.

Finally, the coded bit sequence obtained after the spatially coupled LDPC encoding or a portion of the bits in the coded bit sequence is transmitted. In the coded bit sequence, a portion or all of the bits in each sub-codeblock are selected for transmission. A circular buffer may be used to store all bits of each sub-codeblock in advance. Bits are cyclically selected according to a predefined starting position to obtain a rate-matched bit sequence of a required specific number of bits. The rate-matched bit sequence is then transmitted.

### Example nine

In this example, the number of systematic bits of a sub-codeblock of the spatially coupled LDPC coding is set to K, the length of the to-be-encoded bit sequence is set to A, the maximum number of bits of a CRC-coded sequence is set to C, and the number of CRC parity bits is set to Lcrc. In this example, the number of CRC-coded sequences is determined by the following parameters: the length of the to-be-encoded bit sequence, the maximum number of bits of a CRC-coded sequence, and the number of CRC parity bits.

First, the to-be-encoded bit sequence is segmented and subjected to CRC encoding to obtain multiple CRC-coded sequences. The number of CRC-coded sequences and the number of information bits in the CRC-coded sequences are determined as follows:
1. The number of CRC-coded sequences is determined by the following formula: $X = \left⌊A/\left(C-Lcrc\right)\right⌋$ . Here, X is an integer greater than or equal to 1. The calculation formula $\left⌊x\right⌋$ represents taking the largest integer less than or equal to x.
2. The number of information bits of CRC encoding is determined. The numbers of information bits in the X CRC-coded sequences all equal the difference between the maximum number of bits of a CRC-coded sequence and the number of CRC parity bits.

Next, spatially coupled LDPC encoding is performed on the multiple CRC-coded sequences to obtain a coded bit sequence. The number of sub-codeblocks and the length of the information sequence of the sub-codeblock in the spatially coupled LDPC coding are determined as follows:

The number of sub-codeblocks of the spatially coupled LDPC coding is determined by the following formula: $L = \left⌈\left(A+X\times Lcrc\right)/K\right⌉$*.*

The length of the information sequence of each of the L sub-codeblocks in the spatially coupled LDPC coding is determined as follows: (1) The length of the information sequence of the 0-th to (H-1)-th sub-codeblocks is $\left⌈\left(A+X⋅{L}_{crc}\right)/L\right⌉$*.* (2) The length of the information sequence of the H-th to (L-1)-th sub-codeblocks is $\left⌊\left(A+X⋅{L}_{crc}\right)/L\right⌋$*.* Here, *H* = *mod*(*A + X* · *L_{crc}*, *L*).

In a specific example, the number of systematic bits of a sub-codeblock of the spatially coupled LDPC coding is set to K=512, the length of the to-be-encoded bit sequence is set to A=800000, the maximum number of bits of a CRC-coded sequence is set to C=8448, and the number of CRC parity bits is set to Lcrc=24. The to-be-encoded bit sequence is segmented and subjected to CRC encoding to obtain multiple CRC-coded sequences. The number of CRC-coded sequences and the number of information bits in the CRC-coded sequences are determined as follows:
1. The number of CRC-coded sequences is $X = \left⌊A/\left(C-Lcrc\right)\right⌋ = 94$.
2. The number of bits in all 94 CRC-coded sequences equals 8448. That is, the number of information bits in the CRC encoding all equal 8448-24=8424.

Next, spatially coupled LDPC encoding is performed on the 17 CRC-coded sequences to obtain a coded bit sequence. The number of sub-codeblocks and the length of the information sequence of the sub-codeblock in the spatially coupled LDPC coding are determined as follows:

The number of sub-codeblocks of the spatially coupled LDPC coding is $L =$= $\left⌈\left(A+X\times Lcrc\right)/K\right⌉ = 1567$.

The length of the information sequence of the L=1567 sub-codeblocks in the spatially coupled LDPC coding is as follows: (1) The length of the information sequence of the 0-th to (H-1=1518)-th sub-codeblocks is $\left⌈\left(A+X⋅{L}_{crc}\right)/L\right⌉ = 512$. (2) The length of the information sequence of the H=1519-th to (L-1=1566)-th sub-codeblocks is $\left⌊\left(A+X⋅{L}_{crc}\right)/L\right⌋ = 511$. Here, *H* = *mod*(*A* + *X* · *L_{crc}*, *L*) = 1519.

Finally, the coded bit sequence obtained after the spatially coupled LDPC encoding or a portion of the bits in the coded bit sequence is transmitted. In the coded bit sequence, a portion or all of the bits in each sub-codeblock are selected for transmission. A circular buffer may be used to store all bits of each sub-codeblock in advance. Bits are cyclically selected according to a predefined starting position to obtain a rate-matched bit sequence of a required specific number of bits. The rate-matched bit sequence is then transmitted.

### Example ten

In this example, the number of systematic bits of a sub-codeblock of the spatially coupled LDPC coding is set to K, the length of the to-be-encoded bit sequence is set to A, the maximum number of bits of a CRC-coded sequence is set to C, and the number of CRC parity bits is set to Lcrc. The maximum number of bits of a CRC-coded sequence is greater than or equal to W times the number of systematic bits of a sub-codeblock of the spatially coupled LDPC coding, where W equals at least one of the following: 2, 3, 4, 5, 6, 7, 8, 10, 12, 14, 16, 20, 24, or 32.

First, the to-be-encoded bit sequence is segmented and subjected to CRC encoding to obtain multiple CRC-coded sequences. The number of CRC-coded sequences and the number of information bits in the CRC-coded sequences are determined as follows:
1. The number of CRC-coded sequences is determined by the following formula: $X = \left⌈A/\left(C-Lcrc\right)\right⌉$ *.*
2. The number of information bits of CRC encoding is determined. The number of bits in the first G CRC-coded sequences all equal $\left⌈A/X\right⌉$*,* and the number of bits in the last X-G CRC-coded sequences all equal $\left⌊A/X\right⌋$*.* Here, *G* = *mod*(*A, X*).

Next, spatially coupled LDPC encoding is performed on the multiple CRC-coded sequences to obtain a coded bit sequence. The number of sub-codeblocks and the length of the information sequence of the sub-codeblock in the spatially coupled LDPC coding are determined as follows:

The number of sub-codeblocks of the spatially coupled LDPC coding is determined by the following formula: $L = \left⌈\left(A+X\times Lcrc\right)/K\right⌉$*.*

The length of the information sequence of each of the L sub-codeblocks in the spatially coupled LDPC coding is determined as follows: (1) The length of the information sequence of the 0-th to (H-1)-th sub-codeblocks is $\left⌈\left(A+X⋅{L}_{crc}\right)/L\right⌉$*.* (2) The length of the information sequence of the H-th to (L-1)-th sub-codeblocks is $\left⌊\left(A+X⋅{L}_{crc}\right)/L\right⌋$*.* Here, *H* = *mod*(*A + X · L_{crc}*, *L*).

In a specific example, the number of systematic bits of a sub-codeblock of the spatially coupled LDPC coding is set to K=512, the length of the to-be-encoded bit sequence is set to A=160000, the maximum number of bits of a CRC-coded sequence is set to C=8448, and the number of CRC parity bits is set to Lcrc=24. That is, the maximum number of bits of a CRC-coded sequence is greater than or equal to W times the number of systematic bits of a sub-codeblock of the spatially coupled LDPC coding, where W equals 16. The to-be-encoded bit sequence is segmented and subjected to CRC encoding to obtain multiple CRC-coded sequences. The number of CRC-coded sequences and the number of information bits in the CRC-coded sequences are determined as follows:
1. The number of CRC-coded sequences is $X = \left⌈A/\left(C-Lcrc\right)\right⌉ = 19$.
2. The number of bits in the first G (=1) CRC-coded sequences all equal $\left⌈A/X\right⌉ = 8422$, and the number of bits in the last X-G=18 CRC-coded sequences all equal $\left⌊A/X\right⌋ = 8421$. Here, *G = mod(A, X) = 1.*

Next, spatially coupled LDPC encoding is performed on the 19 CRC-coded sequences to obtain a coded bit sequence. The number of sub-codeblocks and the length of the information sequence of the sub-codeblock in the spatially coupled LDPC coding are determined as follows:

The number of sub-codeblocks of the spatially coupled LDPC coding is $L = \left⌈\left(A+X\times Lcrc\right)/K\right⌉ = 314$ .

The length of the information sequence of the L=314 sub-codeblocks in the spatially coupled LDPC coding is as follows: (1) The length of the information sequence of the 0-th to (H-1=1)-th sub-codeblocks is $\left⌈\left(A+X⋅{L}_{crc}\right)/L\right⌉ = 512$. (2) The length of the information sequence of the H=2-th to (L-1=313)-th sub-codeblocks is $\left⌊\left(A+X⋅{L}_{crc}\right)/L\right⌋ = 511$. Here, *H* = *mod*(*A + X · L_{crc}*, *L*) = 2.

In another specific example, the number of systematic bits of a sub-codeblock of the spatially coupled LDPC coding is K = 1024, and the maximum number of bits of a CRC-coded sequence is C = 8448. That is, the maximum number of bits of a CRC-coded sequence is greater than W times the number of systematic bits of a sub-codeblock of the spatially coupled LDPC coding, where W equals 8.

In another specific example, the number of systematic bits of a sub-codeblock of the spatially coupled LDPC coding is K = 1000, and the maximum number of bits of a CRC-coded sequence is C = 4096. That is, the maximum number of bits of a CRC-coded sequence is greater than W times the number of systematic bits of a sub-codeblock of the spatially coupled LDPC coding, where W equals 4.

In another specific example, the number of systematic bits of a sub-codeblock of the spatially coupled LDPC coding is K = 1024, and the maximum number of bits of a CRC-coded sequence is C = 2048. That is, the maximum number of bits of a CRC-coded sequence is greater than W times the number of systematic bits of a sub-codeblock of the spatially coupled LDPC coding, where W equals 2.

In another specific example, the number of systematic bits of a sub-codeblock of the spatially coupled LDPC coding is K = 1024, and the maximum number of bits of a CRC-coded sequence is C = 6144. That is, the maximum number of bits of a CRC-coded sequence is greater than W times the number of systematic bits of a sub-codeblock of the spatially coupled LDPC coding, where W equals 6.

In another specific example, the number of systematic bits of a sub-codeblock of the spatially coupled LDPC coding is K = 512, and the maximum number of bits of a CRC-coded sequence is C = 8192. That is, the maximum number of bits of a CRC-coded sequence is greater than W times the number of systematic bits of a sub-codeblock of the spatially coupled LDPC coding, where W equals 16.

In another specific example, the number of systematic bits of a sub-codeblock of the spatially coupled LDPC coding is K = 512, and the maximum number of bits of a CRC-coded sequence is C = 16384. That is, the maximum number of bits of a CRC-coded sequence is greater than W times the number of systematic bits of a sub-codeblock of the spatially coupled LDPC coding, where W equals 32.

Finally, the coded bit sequence obtained after the spatially coupled LDPC encoding or a portion of the bits in the coded bit sequence is transmitted. In the coded bit sequence, a portion or all of the bits in each sub-codeblock are selected for transmission. A circular buffer may be used to store all bits of each sub-codeblock in advance. Bits are cyclically selected according to a predefined starting position to obtain a rate-matched bit sequence of a required specific number of bits. The rate-matched bit sequence is then transmitted.

### Example eleven

This example differs from example one in that the number of bits in the CRC-coded sequence in this example is determined by at least one of the following parameters: a transport block size, a code rate, or the length of the to-be-encoded bit sequence.

In an example, the number of bits in the CRC-coded sequence is determined by the following parameter: a transport block size. The number of bits in the CRC-coded sequence may be determined according to the transport block size. For example, when the transport block size is relatively small, CRC encoding is performed directly on the transport block to obtain one CRC-coded sequence, and the number of bits in the CRC-coded sequence equals the sum of the transport block size and the number of CRC parity bits. When the transport block size is relatively large, the number of bits in the CRC-coded sequence is determined by the length of the sub-bit sequences after segmentation of the transport block. In an example, a second threshold exists. When the transport block size is less than or equal to the second threshold, the number of bits in the CRC-coded sequence equals the sum of the transport block size and the number of CRC parity bits. When the transport block size is greater than the second threshold, the number of bits in the CRC-coded sequence equals D, where D is a positive integer. The second threshold is an integer greater than or equal to 1024. In an example, the second threshold may equal 2048, 4096, 6144, 8000, 8192, 8448, or 16384.

In another example, the number of bits in the CRC-coded sequence is determined by the following parameter: the length of the to-be-encoded bit sequence. The number of bits in the CRC-coded sequence may be determined according to the length of the to-be-encoded bit sequence. For example, when the length of the to-be-encoded bit sequence is relatively small, CRC encoding is performed directly on the to-be-encoded bit sequence to obtain one CRC-coded sequence, and the number of bits in the CRC-coded sequence equals the sum of the length of the to-be-encoded bit sequence and the number of CRC parity bits. When the length of the to-be-encoded bit sequence is relatively large, the number of bits in the CRC-coded sequence is determined by the length of the sub-bit sequences after segmentation of the to-be-encoded bit sequence. In an example, a third threshold exists. When the length of the to-be-encoded bit sequence is less than or equal to the third threshold, the number of bits in the CRC-coded sequence equals the sum of the length of the to-be-encoded bit sequence and the number of CRC parity bits. When the length of the to-be-encoded bit sequence is greater than the third threshold, the number of bits in the CRC-coded sequence equals D, where D is a positive integer. The third threshold is an integer greater than or equal to 1024. In an example, the third threshold may equal 2048, 4096, 6144, 8192, 8448, or 16384.

In another example, the number of bits in the CRC-coded sequence is determined by the following parameter: a code rate. The number of bits in the CRC-coded sequence may be determined according to the code rate. In an example, a fourth threshold exists. When the code rate is less than or equal to the fourth threshold, the number of bits in the CRC-coded sequence equals D1. When the code rate is greater than the fourth threshold, the number of bits in the CRC-coded sequence equals D2. The fourth threshold is a real number greater than 0 and less than 1. In an example, the fourth threshold may equal 1/3, 2/5, 1/2, 3/5, 2/3, 3/4, 4/5, 5/6, or 8/9. In addition, D1 and D2 are both positive integers, and D1 is not equal to D2. In an example, D1 is less than D2. In a specific example, the code rate is determined by an MCS index.

In another example, the number of parity bits in the CRC-coded sequence is determined by the following parameter: a code rate. The number of parity bits in the CRC-coded sequence may be determined according to the code rate. In an example, a fourth threshold exists. When the code rate is less than or equal to the fourth threshold, the number of parity bits in the CRC-coded sequence equals D1. When the code rate is greater than the fourth threshold, the number of parity bits in the CRC-coded sequence equals D2. The fourth threshold is a real number greater than 0 and less than 1. In an example, the fourth threshold may equal 1/3, 2/5, 1/2, 3/5, 2/3, 3/4, 4/5, 5/6, or 8/9. In an example, D1 may equal 16, and D2 may equal 24; alternatively, D1 may equal 12, and D2 may equal 24. The number of parity bits in the CRC-coded sequence is determined according to the code rate, and the number of CRC parity bits in the CRC-coded sequence may be selected from at least one of the following: 6, 8, 11, 12, 14, 16, 18, 20, 24, or 32.

In an example, the number of bits in the CRC-coded sequence is determined by the following parameters: a transport block size and a code rate. The transport block size is set to TBS, and the code rate is set to R. The number of bits in the CRC-coded sequence may be determined according to the transport block size TBS and the code rate R. In an example, when the transport block size TBS is less than or equal to the second threshold and the code rate R is less than or equal to the fourth threshold, the number of bits in the CRC-coded sequence equals D1. When the transport block size TBS is greater than the second threshold and the code rate R is less than or equal to the fourth threshold, the number of bits in the CRC-coded sequence equals D2. Otherwise, the number of bits in the CRC-coded sequence equals D3. The second threshold is an integer greater than or equal to 1024. The fourth threshold is a real number greater than 0 and less than 1. In an example, the second threshold may equal 2048, 4096, 6144, 8000, 8192, 8448, or 16384. The fourth threshold may equal 1/3, 2/5, 1/2, 3/5, 2/3, 3/4, 4/5, 5/6, or 8/9. In addition, D1, D2, and D3 are all positive integers, and D1, D2, and D3 are different from each other. In an example, D1 is less than D2, and D2 is less than D3.

### Example twelve

In this example, the number of CRC-coded sequences is determined by at least one of the following parameters: the length of a sub-codeblock information sequence of the spatially coupled LDPC coding, the number of systematic bits of a sub-codeblock of the spatially coupled LDPC coding, the number of sub-codeblocks of the spatially coupled LDPC coding, the length of the to-be-encoded bit sequence, the number of CRC parity bits, a transport block size, a period of a base graph matrix of the spatially coupled LDPC coding, a period of a base matrix of the spatially coupled LDPC coding, the maximum number of bits of a CRC-coded sequence, or a code rate.

In this example, the number of bits in the CRC-coded sequence is determined at least by the length of a sub-codeblock information sequence of the spatially coupled LDPC coding. This example includes S1 to S4 described below.

In S1, a to-be-encoded bit sequence is determined. The to-be-encoded bit sequence is set as *a*₀, *a*₁, *a*₂, *a*₃, ..., *a*_{*A*-1}, and the number of bits is A.

In S2, CRC encoding is performed on the to-be-encoded bit sequence to obtain X CRC-coded sequences, where X is an integer greater than 0.

It is assumed that the number of CRC parity bits equals Lcrc, and the number of bits in a CRC-coded sequence equals B. The number X of CRC-coded sequences is determined by the following parameters: the length of a sub-codeblock information sequence of the spatially coupled LDPC coding and the length of the to-be-encoded bit sequence. In an example, X is determined by the following formula: $X = \left⌈A/\left(K⋅16\right)\right⌉$, where A is the length of the to-be-encoded bit sequence, K is the length of a sub-codeblock information sequence of the spatially coupled LDPC coding, and both A and K are integers greater than 0.

Alternatively, the number X of CRC-coded sequences is determined by the following parameter: the number of sub-codeblocks of the spatially coupled LDPC coding. In an example, X is determined by the following formula: $X = \left⌈L/12\right⌉$, where L is the number of sub-codeblocks of the spatially coupled LDPC coding, and L is an integer greater than 0.

Alternatively, the number X of CRC-coded sequences is determined by the following parameter: the number of CRC parity bits. The number of CRC parity bits is set to Lcrc. In an example, many choices exist for Lcrc, and the corresponding number X of CRC-coded sequences differs under different choices. In an example, two selectable numbers (Lcrc1 and Lcrc2) of CRC parity bits exist. If the number of CRC parity bits is Lcrc1, the corresponding number X of CRC-coded sequences equals X1. If the number of CRC parity bits is Lcrc2, the corresponding number X of CRC-coded sequences equals X2. Then, if Lcrc1 is less than Lcrc2, X1 is less than X2, where X1 and X2 are both positive integers. In an example, Lcrc1 equals 16, and Lcrc2 equals 24. Then, if the number of CRC parity bits is configured as Lcrc1=16, the corresponding number X of CRC-coded sequences equals X1=10. If the number of CRC parity bits is configured as Lcrc2=24, the corresponding number X of CRC-coded sequences equals X2=20.

Alternatively, the number X of CRC-coded sequences is determined by the following parameter: the number of sub-codeblocks of the spatially coupled LDPC coding. In an example, X is determined by the following formula: $X = \left⌈L/12\right⌉$, where L is the number of sub-codeblocks of the spatially coupled LDPC coding, and L is an integer greater than 0.

The to-be-encoded bit sequence is divided into blocks to obtain X sub-bit sequences. CRC encoding is then performed on each of the X sub-bit sequences to obtain CRC-coded sequences, thereby obtaining X CRC-coded sequences. CRC encoding produces a CRC parity bit sequence with the number of bits equal to Lcrc. The CRC parity bit sequence is combined with the sub-bit sequence to obtain a CRC-coded sequence.

In S3, spatially coupled LDPC encoding is performed on the X CRC-coded sequences to obtain a coded bit sequence.

In an example, the length of a sub-codeblock information sequence of the spatially coupled LDPC coding is K = 400, and the number of sub-codeblocks of the spatially coupled LDPC coding is L = 160. In this example, the to-be-encoded bit sequence is *a*₀, *a*₁, *a*₂, *a*₃, ..., *a*_{*A*-1}, where A equals 200000. In this example, in the spatially coupled LDPC coding base matrix, the coupling width *mₛ* equals 2, the period of the base matrix of the spatially coupled LDPC coding equals 3, the lifting size Z equals 400, the number of rows in the sub-base matrix is mb = 1, and the number of columns in the sub-base matrix is nb = 2. In the 0-th forward check base matrix, the corresponding 0-th sub-base matrix $H {b}_{0}^{\left(0\right)}$ is [188, 0], the 1-st sub-base matrix $H {b}_{1}^{\left(0\right)}$ is [82, 201], and the 2-nd sub-base matrix $H {b}_{2}^{\left(0\right)}$ is [226, 266]. In the 1-st forward check base matrix, the corresponding 0-th sub-base matrix $H {b}_{0}^{\left(1\right)}$ is [319, 0], the 1-st sub-base matrix $H {b}_{1}^{\left(1\right)}$ is [70, 315], and the 2-nd sub-base matrix $H {b}_{2}^{\left(1\right)}$ is [1, 157]. In the 2-nd forward check base matrix, the corresponding 0-th sub-base matrix $H {b}_{0}^{\left(2\right)}$ is [199, 0], the 1-st sub-base matrix $H {b}_{1}^{\left(2\right)}$ is [339, 190], and the 2-nd sub-base matrix $H {b}_{2}^{\left(2\right)}$ is [337, 269]. In the spatially coupled LDPC coding, the number of bits in each sub-codeblock equals N = nb*Z = 2*400 = 800. The information bit length of each sub-codeblock equals K=kb*Z=1*400=400. The length of parity bits in each sub-codeblock equals M=N-K=400. The number of bits in the tail check sequence equals Ms*M=800.

In S4, the coded bit sequence or a portion of the bits in the coded bit sequence is transmitted.

In the coded bit sequence, a portion or all of the bits in each sub-codeblock are selected for transmission. A circular buffer may be used to store all bits of each sub-codeblock in advance. Bits are cyclically selected according to a predefined starting position to obtain a rate-matched bit sequence of a required specific number of bits. The rate-matched bit sequence is then transmitted.

In an example, the number X of CRC-coded sequences is determined by the following parameters: the length K of a sub-codeblock information sequence of the spatially coupled LDPC coding and the length A of the to-be-encoded bit sequence. That is, X is determined by the following formula: $X = \left⌈A/\left(K⋅16\right)\right⌉ = 32$. The encoding chain length of the spatially coupled LDPC coding is $L = \left⌈\left(A+X⋅24\right)/400\right⌉ = 502$. The length of the information sequence of the first 501 sub-codeblocks equals $\left⌈\left(A+X⋅24\right)/502\right⌉ = 400$, and the length of the information sequence of the last sub-codeblock is (*A* + *X* · 24) - 400 · 501 = 368. CRC encoding is performed on the to-be-encoded bit sequence to obtain X=32 CRC-coded sequences. The i-th CRC-coded sequence corresponds to the information sequences of the i*16-th to ((i+1)*16-1)-th sub-codeblocks of the spatially coupled LDPC coding, where i equals 0, 1, 2, ..., 21. The j-th CRC-coded sequence corresponds to the information sequences of the (16*16+j*15)-th to (16*16+(j+1)*15-1)-th sub-codeblocks of the spatially coupled LDPC coding, where j equals 22, 23, 24, ..., 31. That is, each of the first 22 CRC-coded sequences corresponds to information sequences of 16 sub-codeblocks of the spatially coupled LDPC coding (each with a length of 400*16=6400), and each of the last 10 CRC-coded sequences corresponds to information sequences of 15 sub-codeblocks of the spatially coupled LDPC coding. The coded bit sequence obtained after the spatially coupled LDPC encoding includes L=502 sub-codeblocks. The length of the first 501 sub-codeblocks is 800, and the length of the last sub-codeblock is 768. Finally, the coded bit sequence or a portion of the bits in the coded bit sequence is transmitted. The total length of the coded bit sequence is 800*501+768=401568 bits.

Alternatively, the number X of CRC-coded sequences is determined by the following parameter: the number L of sub-codeblocks of the spatially coupled LDPC coding. In an example, L equals 500, and X is determined by the following formula: $X = \left⌈L/12\right⌉ = 42$. The encoding chain length of the spatially coupled LDPC coding is $L = \left⌈\left(A+X⋅24\right)/400\right⌉ = 503$. The length of the information sequence of the first 501 sub-codeblocks equals $\left⌈\left(A+X⋅24\right)/503\right⌉ = 400$, and the length of the information sequence of the last sub-codeblock is (*A* + *X* · 24) - 400 · 502 = 208. CRC encoding is performed on the to-be-encoded bit sequence to obtain X=42 CRC-coded sequences. The i-th CRC-coded sequence corresponds to the information sequences of the i*12-th to ((i+1)*12-1)-th sub-codeblocks of the spatially coupled LDPC coding, where i equals 0, 1, 2, ..., 40. The j-th CRC-coded sequence corresponds to the information sequences of the (12*41+j*11)-th to (12*41+(j+1)*11-1)-th sub-codeblocks of the spatially coupled LDPC coding, where j equals 41. That is, each of the first 41 CRC-coded sequences corresponds to information sequences of 12 sub-codeblocks of the spatially coupled LDPC coding, and the last CRC-coded sequence corresponds to information sequences of 11 sub-codeblocks of the spatially coupled LDPC coding. The coded bit sequence obtained after the spatially coupled LDPC coding includes L=503 sub-codeblocks. The length of the first 502 sub-codeblocks is 800, and the length of the last sub-codeblock is 608. Finally, the coded bit sequence or a portion of the bits in the coded bit sequence is transmitted. The total length of the coded bit sequence is 800*502+608 = 402208 bits.

In embodiment two, FIG. 6 is a flowchart of another data transmission method according to an embodiment of the present application. This data reception process is described in this embodiment. In this embodiment, a data reception method is illustrated. As shown in FIG. 6, the data transmission method includes S610 and S620.

In S610, to-be-decoded data is acquired.

It is assumed that the length of the acquired to-be-decoded data equals E. The to-be-decoded data includes data of L sub-codeblocks and data of a tail check sequence, where the length of each sub-codeblock equals N, the length of the information sequence of each sub-codeblock equals K, and the length of the tail check sequence equals Ms*M. Here, Ms is the coupling width, and M is the number of parity bits in a sub-codeblock of the spatially coupled LDPC code.

In S620, spatially coupled LDPC decoding and CRC decoding are performed on the to-be-decoded data to obtain a decoded to-be-encoded bit sequence.

Decoding is performed on the data of the L sub-codeblocks of the to-be-decoded data according to the generator polynomial of CRC encoding, the base matrix of the spatially coupled LDPC coding, and the lifting size to obtain the decoded to-be-encoded bit sequence. During the decoding process, if any CRC check of decoded output fails, the entire decoding is terminated. After spatially coupled LDPC decoding is performed on the to-be-decoded data, a first decoded sequence is obtained. The first decoded sequence corresponds to X CRC-coded sequences. CRC decoding is then performed on the first decoded sequence to obtain the corresponding to-be-encoded bit sequence.

In an example, at least one of the X CRC-coded sequences includes at least two sub-codeblock information sequences used in the spatially coupled LDPC coding.

In an example, any one of the X CRC-coded sequences includes at least Y0 sub-codeblock information sequences used in the spatially coupled LDPC coding, where Y0 may equal 2, 4, 6, 8, 10, 12, 14, 16, 18, 20, or 24. In an example, the Y0 sub-codeblocks in the spatially coupled LDPC coding are Y0 consecutive sub-codeblock information sequences, that is, all sub-codeblocks corresponding to the Y0 sub-codeblock information sequences are pairwise adjacent.

In an example, the number of bits in the CRC-coded sequence is determined by at least one of the following parameters: the length of a sub-codeblock information sequence of the spatially coupled LDPC coding; the number of systematic bits of a sub-codeblock of the spatially coupled LDPC coding; the number of sub-codeblocks of the spatially coupled LDPC coding; the length of the to-be-encoded bit sequence; the number of CRC parity bits; a transport block size; a period of a base graph matrix of the spatially coupled LDPC coding; a period of a base matrix of the spatially coupled LDPC coding; the maximum number of bits of an information sequence of the CRC encoding; the maximum number of bits of a CRC-coded sequence; or a code rate.

In an example, at least one of the X CRC-coded sequences has a number of bits equal to the sum of the lengths of Y sub-codeblock information sequences used in the spatially coupled LDPC coding, where Y is an integer greater than 1. In an example, X is an integer greater than 0.

In an example, the number of bits in the CRC-coded sequence is determined by at least one of the following parameters: the length of a sub-codeblock information sequence of the spatially coupled LDPC coding; the number of systematic bits of a sub-codeblock of the spatially coupled LDPC coding; the number of sub-codeblocks of the spatially coupled LDPC coding; the length of the to-be-encoded bit sequence; the number of CRC parity bits; a transport block size; a period of a base graph matrix of the spatially coupled LDPC coding; a period of a base matrix of the spatially coupled LDPC coding; the maximum number of bits of an information sequence of the CRC encoding; the maximum number of bits of a CRC-coded sequence; or a code rate.

In an example, the number of bits in a CRC-coded sequence equals the sum of the lengths of Y consecutive sub-codeblock information sequences used in the spatially coupled LDPC coding. In an example, Y is an integer greater than 1 and less than the number of sub-codeblocks of the spatially coupled LDPC coding. In an example, Y may equal 4, 6, 8, 10, 12, 16, 20, 24, 28, or 32.

In an example, X1 CRC-coded sequences exist among the X CRC-coded sequences, and the number of bits in each of the X1 CRC-coded sequences equals the sum of the lengths of Y1 sub-codeblock information sequences used in the spatially coupled LDPC coding. X2 CRC-coded sequences exist among the X CRC-coded sequences, and the number of bits in each of the X2 CRC-coded sequences equals the sum of the lengths of Y2 sub-codeblock information sequences used in the spatially coupled LDPC coding. X1 and X2 are both non-negative integers, and the sum of X1 and X2 equals X. Y1 and Y2 are both non-negative integers, and the sum of Y1 and Y2 equals L, where L is the number of sub-codeblocks of the spatially coupled LDPC coding. In an example, the difference between Y1 and Y2 is not greater than 1.

In at least one of the X CRC-coded sequences, all bits are placed in Y2 consecutive sub-codeblock information sequences in the spatially coupled LDPC coding, where Y2 is a positive integer multiple of T0, is a positive integer multiple of T1, or is a positive integer multiple of T0*T1. Here, T0 is the period of the base graph matrix of the spatially coupled LDPC coding, T1 is the period of the base matrix of the spatially coupled LDPC coding, and both T0 and T1 are positive integers.

The number of CRC parity bits in the CRC-coded sequence obtained by the CRC encoding may include at least one of the following: 6, 8, 11, 12, 14, 16, 18, 20, 24, or 32.

In an embodiment, the number of sub-codeblocks of the spatially coupled LDPC coding is an integer greater than 1. In a specific example, the minimum number of sub-codeblocks of the spatially coupled LDPC coding equals one of the following: 4, 6, 8, 10, 12, 16, 24, or 32.

In an example, the maximum number of bits of the CRC-coded sequence may include at least one of the following: 4096, 6144, 8192, 8448, or 16384.

In an embodiment, the maximum number of bits of an information sequence of the CRC encoding is an integer greater than 1024 and less than or equal to 16384.

In an embodiment, the length of a sub-codeblock information sequence of the spatially coupled LDPC coding is an integer greater than or equal to 128 and less than or equal to 8448.

In an embodiment, the number of systematic bits of a sub-codeblock of the spatially coupled LDPC coding equals at least one of the following: 128, 256, 400, 512, 600, 800, 1024, 1536, 2048, 3072, or 4096. The sub-codeblock systematic bits include an information sequence and padding bits in a sub-codeblock of the spatially coupled LDPC coding. That is, the number of sub-codeblock systematic bits equals the sum of the length of the information sequence and the number of padding bits in the sub-codeblock of the spatially coupled LDPC coding. The number of padding bits is a non-negative integer. If no padding is required, the number of padding bits equals 0.

In an example, the length of a sub-codeblock information sequence of the spatially coupled LDPC coding may include at least one of the following: 128, 256, 400, 600, 512, 768, 800, 1024, 2048, or 4096.

In an embodiment, the number of CRC-coded sequences is at least equal to 2.

In an embodiment, the number of sub-codeblock information sequences included in a CRC-coded sequence includes one of the following: 2, 4, 6, 8, 10, 12, 14, 16, 18, 20, or 24.

In an embodiment, the maximum number of sub-codeblock information sequences included in a CRC-coded sequence equals at least one of the following: 4, 6, 8, 10, 12, 14, 16, 18, 20, or 24.

For any example of embodiment one, a corresponding receiving method example may exist. Here, only the receiving method example for example one in embodiment one is described, and other examples are not repeated.

First, to-be-decoded data with a length of E=82944 is received and acquired. The to-be-decoded data may be log-likelihood ratio information, where each piece of log-likelihood ratio information describes the reliability metric of a corresponding received bit. The to-be-decoded data includes data of L sub-codeblocks and data of a tail check sequence, where the length of each sub-codeblock equals N=1024, the length of the information sequence of each sub-codeblock equals K=512, and the length of the tail check sequence equals 1024.

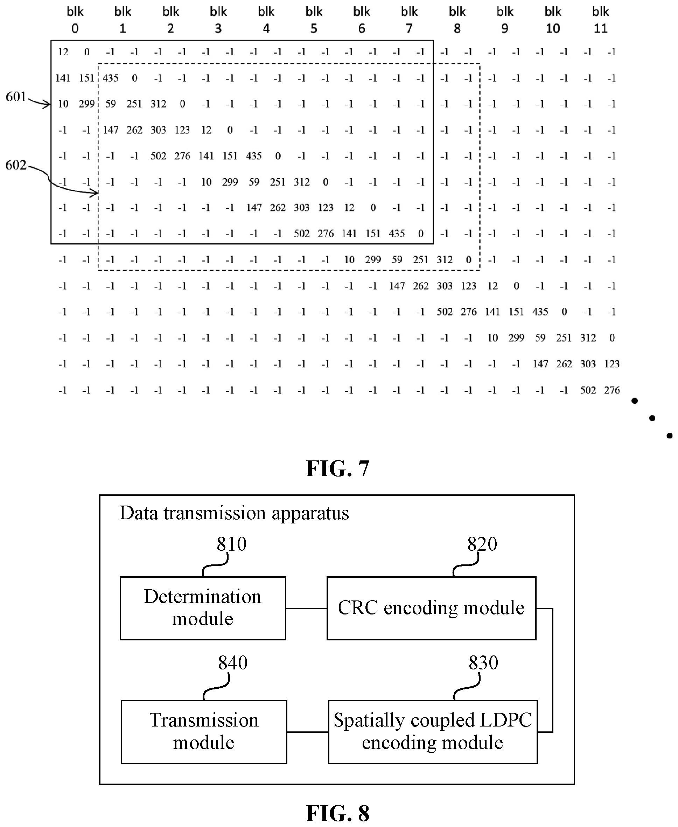

Next, spatially coupled LDPC decoding is performed on the to-be-decoded data to obtain decoded data. Decoding is performed on the data of the L sub-codeblocks of the to-be-decoded data according to the generator polynomial of CRC encoding, the base matrix of the spatially coupled LDPC coding, and the lifting size to obtain the decoded data. During the decoding process, if any CRC check of decoded output fails, the entire decoding is terminated. The decoded data corresponds to X CRC-coded sequences. A sliding window decoding method is used to decode the to-be-decoded data. In this example, the decoding window length is assumed to be 8 (that is, 8 sub-codeblocks are updated simultaneously, and the first sub-codeblock is regarded as the target sub-codeblock). FIG. 7 is a diagram illustrating an implementation of decoding according to an embodiment of the present application. As shown in FIG. 7, the decoding window 601 corresponding to the solid-line box includes 8 sub-codeblocks (the indices of the sub-codeblocks in the window are 0, 1, 2, ..., 7), and the index of the target sub-codeblock of the current decoding window is 0. The decoding window 602 corresponding to the dashed-line box also includes 8 sub-codeblocks (the indices of the sub-codeblocks in the window are 1, 2, 3, ..., 8), and the index of the target sub-codeblock of the current decoding window is 1. After the decoding window 601 completes the decoding iteration update, the target sub-codeblock 0 in the window outputs the decoding result by hard decision. Then, the decoding window slides one sub-codeblock to the right, and the corresponding decoding window 602 continues the decoding iteration update with the target sub-codeblock being 1. After the number of iterations reaches a certain number, the target sub-codeblock 1 outputs the decoding result by hard decision. By analogy, the decoding window continues to slide one sub-codeblock to the right and continues the decoding iteration update until the last sub-codeblock outputs the result by hard decision, at which point decoding stops.

During the sliding window decoding process, when Y sub-codeblock information sequences are output by hard decision, CRC check may be performed immediately. If the CRC check passes, it indicates that the information sequences of the current Y consecutive sub-codeblocks output by decoding have no errors, and the decoding window may continue to slide for decoding. If the CRC check fails, it indicates that errors exist in the information sequences of the current Y consecutive sub-codeblocks output by decoding, and the sliding window decoding may be stopped immediately, thereby reducing decoding computation updates and lowering the power consumption of decoding at the receiving end. In addition, since a decoding error has been detected in advance during decoding, the transmitting end may be quickly notified to retransmit the data of the current transport block, thereby reducing the reception latency. The CRC-coded sequence includes multiple sub-codeblock information sequences used in the spatially coupled LDPC coding, which makes the CRC check more efficient. If CRC encoding is performed on the information sequence of each sub-codeblock, the CRC overhead is very large. Moreover, when the sliding window decoding outputs the information sequence of each of Y consecutive sub-codeblocks, CRC check calculation may be performed simultaneously. When the last information sequence of the Y sub-codeblocks is output, the final check of a CRC-coded sequence is completed. Of course, the inherent check relationship of the spatially coupled LDPC code and the CRC check may be used together as the termination condition for sliding window iteration.

In this example, sliding window decoding is performed on the to-be-decoded data, and Y=16 sub-codeblocks are output sequentially. The combination of the information sequences of these Y=16 sub-codeblocks constitutes one CRC-coded sequence. CRC encoding check is performed using the generator polynomial. If the check passes, it indicates that the information sequences of these Y=16 sub-codeblocks have no errors, and the decoding window continues to slide for decoding. If the CRC check fails, the entire sliding window decoding is terminated, thus reducing unnecessary iteration update calculations. In addition, if the CRC check fails, the transmitting end may be immediately notified to retransmit the data. After the retransmitted data is received, sliding window decoding may start from the sub-codeblock position where the CRC check failed, without repeating decoding on the sub-codeblocks that have already been correctly decoded. This configuration can effectively reduce decoding power consumption and decoding reception latency, and improve the decoding throughput of the entire communication system.

In this example, the number B of bits in each CRC-coded sequence equals 8192. The 0-th CRC-coded sequence corresponds to information sequences of consecutive 0-th to 15-th sub-codeblocks. The 1-st CRC-coded sequence corresponds to information sequences of consecutive 16-th to 31-st sub-codeblocks. The 2-nd CRC-coded sequence corresponds to information sequences of consecutive 32-nd to 47-th sub-codeblocks. The 3-rd CRC-coded sequence corresponds to information sequences of consecutive 48-th to 63-rd sub-codeblocks. The 4-th CRC-coded sequence corresponds to information sequences of consecutive 64-th to 79-th sub-codeblocks. Therefore, assuming that the decoding window size of the sliding window decoding is 8 sub-codeblocks, upon receiving the data of the 0-th to 7-th sub-codeblocks in the to-be-decoded data, sliding window decoding may be started to output the information sequence of the 0-th sub-codeblock until the information sequence of the 15-th sub-codeblock is output. Then, CRC check is performed on the data block merged from the information sequences of the 0-th to 15-th sub-codeblocks. If the CRC check passes, the process switches to the next decoding window to continue decoding. Otherwise, decoding is terminated. The process continues sequentially until the check of the last CRC-coded sequence passes, at which point the decoding is correct.

For any example in embodiment one, a corresponding receiving processing method example may exist. These examples are not repeated here.

In an embodiment, FIG. 8 is a block diagram illustrating the structure of a data transmission apparatus according to an embodiment of the present application. This embodiment is applied to a first communication device. As shown in FIG. 8, the data transmission apparatus in this embodiment includes a determination module 810, a CRC encoding module 820, a spatially coupled LDPC encoding module 830, and a transmission module 840.

The determination module 810 is configured to determine a to-be-encoded bit sequence.

The to-be-encoded bit sequence may be a bit sequence to which a transport block-level CRC has been added, or may be a bit sequence to which no transport block-level CRC has been added. In an example, the to-be-encoded bit sequence is denoted as *a*₀, *a*₁, *a*₂, *a*₃, ..., *a*_{*A*-1}, and the number of bits is A, where A is an integer greater than 0.

The CRC encoding module 820 is configured to perform CRC encoding on the to-be-encoded bit sequence to obtain at least one CRC-coded sequence.

The CRC encoding module may be configured to perform CRC encoding on the to-be-encoded bit sequence to obtain X CRC-coded sequences, where X is an integer greater than 0. The to-be-encoded bit sequence is first divided into X sub-bit sequences. CRC encoding is then performed on each of the X sub-bit sequences to obtain X CRC-coded sequences. CRC encoding produces a CRC parity bit sequence with a bit length equal to Lcrc. The CRC parity bit sequence is combined with a sub-bit sequence to obtain a CRC-coded sequence. The generator polynomials used for the CRC encoding include any one of the CRC generator polynomials in embodiment one. The number Lcrc of CRC parity bits may include one of the following: 6, 8, 11, 12, 14, 16, 18, 20, 24, or 32.

After CRC encoding is performed on the to-be-encoded bit sequence *a*₀, *a*₁, *a*₂, *a*₃, ..., *a*_{*A*-1}, X CRC-coded sequences are obtained. The i-th CRC-coded sequence is denoted as ${b}_{0}^{i} , {b}_{1}^{i} , {b}_{2}^{i} , {b}_{3}^{i} , … , {b}_{B - 1}^{i}$ and has a length of B, where B is an integer greater than 0. The number B of bits in the CRC-coded sequence is determined by at least one of the following parameters: the length of a sub-codeblock information sequence of the spatially coupled LDPC coding; the number of systematic bits of a sub-codeblock of the spatially coupled LDPC coding; the number of sub-codeblocks of the spatially coupled LDPC coding; the length of the to-be-encoded bit sequence; the number of CRC parity bits; a transport block size; a period of a base graph matrix of the spatially coupled LDPC coding; a period of a base matrix of the spatially coupled LDPC coding; the maximum number of bits of an information sequence of the CRC encoding; the maximum number of bits of a CRC-coded sequence; or a code rate. The specific method for determining the number of bits B in the CRC-coded sequence may refer to the scheme in embodiment one and is not repeated here.

The spatially coupled LDPC encoding module 830 is configured to perform spatially coupled LDPC encoding on the at least one CRC-coded sequence to obtain a coded bit sequence, where the at least one CRC-coded sequence includes at least two sub-codeblock information sequences used in the spatially coupled LDPC coding.

In an example, when encoding is performed using the spatially coupled LDPC code, the length of the obtained coded bit sequence equals L*N + M**mₛ*, where L is the coupling chain length (that is, the number of sub-codeblocks), N is the encoding length of a sub-codeblock, M is the check bit length of a sub-codeblock, and *mₛ* is the coupling width. L, N, M, and *mₛ* are all positive integers. The coded bit sequence includes not only the coded bit sequences of L sub-codeblocks but also a tail bit sequence of length M**mₛ* bits.

In another example, when encoding is performed using the spatially coupled LDPC code, the length of the obtained coded bit sequence equals L*N, where L is the coupling chain length, and N is the encoding length of a sub-codeblock. Both L and N are positive integers. The coded bit sequence includes only the coded bit sequences of L sub-codeblocks. That is, no tail bits exist in the spatially coupled LDPC coding in this case.

The transmission module 840 is configured to transmit at least a portion of bits in the coded bit sequence.

The transmission module is configured to transmit the coded bit sequence or a portion of the bits in the coded bit sequence. In the coded bit sequence, a portion or all of the bits in each sub-codeblock are selected for transmission. A circular buffer may be used to store all bits of each sub-codeblock in advance. Bits are cyclically selected according to a predefined starting position to obtain a rate-matched bit sequence of a required specific number of bits. The rate-matched bit sequence is then transmitted.

In an embodiment, at least one CRC-coded sequence includes a first preset number of sub-codeblock information sequences used in the spatially coupled LDPC coding, where the first preset number is an even number greater than 0. In an example, the first preset number is denoted as Y0. Any one of the X CRC-coded sequences includes at least Y0 sub-codeblock information sequences used in the spatially coupled LDPC coding, where Y0 may equal 2, 4, 6, 8, 10, 12, 14, 16, 18, 20, or 24.

In an embodiment, the at least one CRC-coded sequence includes at least two sub-codeblock information sequences used in the spatially coupled LDPC coding where the at least two sub-codeblock information sequences are consecutive sub-codeblock information sequences in the spatially coupled LDPC coding. In an example, the Y0 sub-codeblocks in the spatially coupled LDPC coding are Y0 consecutive sub-codeblock information sequences, and Y0 is an integer greater than 1.

In an embodiment, at least one CRC-coded sequence includes a second preset number of sub-codeblock information sequences used in the spatially coupled LDPC coding, where the second preset number is a positive integer multiple of a period of a base graph matrix of the spatially coupled LDPC coding, or is a positive integer multiple of a period of a base matrix of the spatially coupled LDPC coding, or is a positive integer multiple of the product of a period of a base graph matrix of the spatially coupled LDPC coding and a period of a base matrix of the spatially coupled LDPC coding. In an example, the second preset number is denoted as Y2. In at least one of the X CRC-coded sequences, all bits are placed in Y2 consecutive sub-codeblock information sequences in the spatially coupled LDPC coding, where Y2 is a positive integer multiple of T0, is a positive integer multiple of T1, or is a positive integer multiple of T0*T1. Here, T0 is the period of the base graph matrix of the spatially coupled LDPC coding, T1 is the period of the base matrix of the spatially coupled LDPC coding, and both T0 and T1 are positive integers.

In an embodiment, the number of bits included in a CRC-coded sequence is determined by at least one of following parameters: the length of a sub-codeblock information sequence of the spatially coupled LDPC coding; the number of systematic bits of a sub-codeblock of the spatially coupled LDPC coding; the number of sub-codeblocks of the spatially coupled LDPC coding; the length of the to-be-encoded bit sequence; the number of CRC parity bits; a transport block size; a period of a base graph matrix of the spatially coupled LDPC coding; a period of a base matrix of the spatially coupled LDPC coding; the maximum number of bits of an information sequence of the CRC encoding; the maximum number of bits of a CRC-coded sequence; or a code rate.

In an embodiment, the number of bits included in at least one CRC-coded sequence is equal to the sum of lengths of a third preset number of sub-codeblock information sequences used in the spatially coupled LDPC coding, where the third preset number is an integer greater than 1 and less than or equal to the number of sub-codeblocks of the spatially coupled LDPC coding. In an example, the third preset number is denoted as Y1 or Y2. X1 CRC-coded sequences exist among the X CRC-coded sequences, and the number of bits in each of the X1 CRC-coded sequences equals the sum of the lengths of Y1 sub-codeblock information sequences used in the spatially coupled LDPC coding. X2 CRC-coded sequences exist among the X CRC-coded sequences, and the number of bits in each of the X2 CRC-coded sequences equals the sum of the lengths of Y2 sub-codeblock information sequences used in the spatially coupled LDPC coding. X1 and X2 are both non-negative integers, and the sum of X1 and X2 equals X. Y1 and Y2 are both non-negative integers, and the sum of Y1 and Y2 equals L, where L is the number of sub-codeblocks of the spatially coupled LDPC coding. In an example, the difference between Y1 and Y2 is not greater than 1.

In an embodiment, the number of CRC-coded sequences is determined by at least one of following parameters: the length of a sub-codeblock information sequence of the spatially coupled LDPC coding; the number of systematic bits of a sub-codeblock of the spatially coupled LDPC coding; the number of sub-codeblocks of the spatially coupled LDPC coding; the length of the to-be-encoded bit sequence; the number of CRC parity bits; a transport block size; a period of a base graph matrix of the spatially coupled LDPC coding; a period of a base matrix of the spatially coupled LDPC coding; the maximum number of bits of an information sequence of the CRC encoding; the maximum number of bits of a CRC-coded sequence; or a code rate.

In an embodiment, in the CRC encoding, at least two CRC-coded sequences are obtained, and numbers of sub-codeblock information sequences included in every two CRC-coded sequences among the at least two CRC-coded sequences are equal to each other.

In an embodiment, in the CRC encoding, at least one CRC-coded sequence is obtained, where the number of bits in at least one CRC-coded sequence is greater than the length of a sub-codeblock information sequence of the spatially coupled LDPC coding. In a specific example, in the CRC encoding, at least one CRC-coded sequence is obtained, where the number of bits in at least one CRC-coded sequence is greater than or equal to H times the length of a sub-codeblock information sequence of the spatially coupled LDPC coding, where H is an integer greater than 1. The length of a sub-codeblock information sequence of the spatially coupled LDPC coding is an integer greater than 0. In a specific example, H equals at least one of the following: 2, 3, 4, 5, 6, 7, 8, 10, 12, 14, 16, 20, 24, or 32.

In an embodiment, the maximum number of bits of a CRC-coded sequence is greater than the number of systematic bits of a sub-codeblock of the spatially coupled LDPC coding. In a specific example, the maximum number of bits of a CRC-coded sequence is greater than or equal to W times the number of systematic bits of a sub-codeblock of the spatially coupled LDPC coding, where W equals at least one of the following: 2, 3, 4, 5, 6, 7, 8, 10, 12, 14, 16, 20, 24, or 32. The maximum number of bits of a CRC-coded sequence is an integer greater than 0, and the number of systematic bits of a sub-codeblock of the spatially coupled LDPC coding is an integer greater than 0.

In an embodiment, in CRC encoding, at least two CRC-coded sequences are obtained, a first value is the maximum value of numbers of sub-codeblock information sequences included in the at least two CRC-coded sequences, and a second value is the minimum value of numbers of sub-codeblock information sequences included in the at least two CRC-coded sequences, where the maximum difference between the first value and the second value is equal to 1.

In an embodiment, in the CRC encoding, a fourth preset number of CRC-coded sequences are obtained, where numbers of sub-codeblock information sequences included in a fifth preset number of CRC-coded sequences are equal, the fourth preset number is an integer greater than 1, and the fifth preset number is obtained by subtracting one from the fourth preset number.

In an embodiment, the number of sub-codeblocks of the spatially coupled LDPC coding is an integer greater than 1.

In an embodiment, the maximum number of bits of a CRC-coded sequence includes at least one of the following: 4096, 6144, 8192, 8448, or 16384.

In an embodiment, the length of a sub-codeblock information sequence of the spatially coupled LDPC coding is an integer greater than or equal to 128 and less than or equal to 8448.

In an embodiment, the number of CRC-coded sequences is at least equal to 2.

In an embodiment, the number of CRC parity bits in a CRC-coded sequence includes one of the following: 6, 8, 11, 12, 14, 16, 18, 20, 24, or 32.

In an embodiment, the number of sub-codeblock information sequences included in a CRC-coded sequence includes one of the following: 2, 4, 6, 8, 10, 12, 14, 16, 18, 20, or 24.

The data transmission apparatus provided in this embodiment is configured to implement the data transmission method applied to the first communication device in the embodiment shown in FIG. 1. The data transmission apparatus provided in this embodiment has similar implementation principles and technical effects, which are not repeated herein.

For any example of embodiment one, a corresponding receiving method example may exist. Here, only the receiving method example corresponding to example one in embodiment one is described, and the others are not repeated.

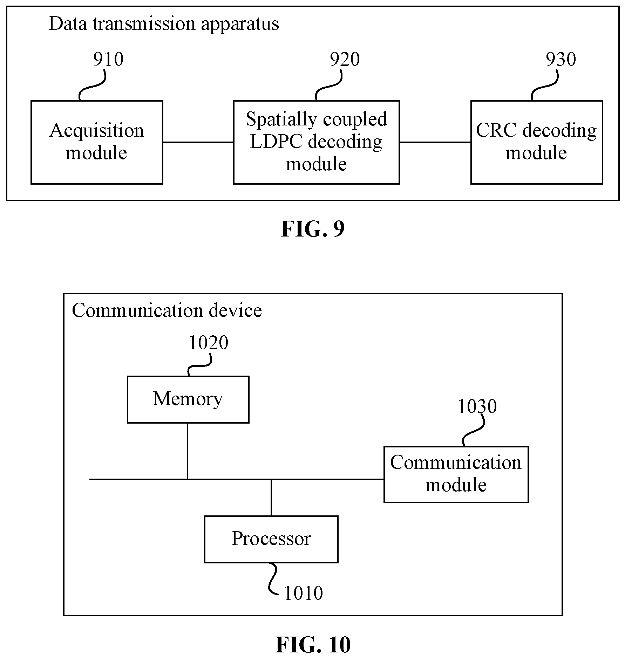

In an embodiment, FIG. 9 is a block diagram illustrating the structure of another data transmission apparatus according to an embodiment of the present application. This embodiment is applied to a second communication device. As shown in FIG. 9, the data transmission apparatus in this embodiment includes an acquisition module 910, a spatially coupled LDPC decoding module 920, and a CRC decoding module 930.

The acquisition module 910 is configured to acquire to-be-decoded data.

The module is configured to receive and acquire to-be-decoded data. It is assumed that the length of the acquired to-be-decoded data equals E. The to-be-decoded data includes data of L sub-codeblocks and data of a tail check sequence, where the length of each sub-codeblock equals N, the length of the information sequence of each sub-codeblock equals K, and the length of the tail check sequence equals Ms*M. Here, Ms is the coupling width, and M is the check bit length of the spatially coupled LDPC code.

The spatially coupled LDPC decoding module 920 is configured to perform spatially coupled LDPC decoding on the to-be-decoded data to obtain at least one first decoded sequence, where the at least one first decoded sequence corresponds to at least one CRC-coded sequence, and the at least one CRC-coded sequence includes at least two sub-codeblock information sequences used in spatially coupled LDPC coding.

Spatially coupled LDPC decoding is performed on the to-be-decoded data to obtain decoded data (which may also be referred to as the first decoded sequence). Decoding is performed on the data of the L sub-codeblocks of the to-be-decoded data according to the generator polynomial of CRC encoding, the base matrix of the spatially coupled LDPC coding, and the lifting size to obtain the decoded data. During the decoding process, if any CRC check of decoded output fails, the entire decoding is terminated. The decoded data corresponds to X CRC-coded sequences.

In the spatially coupled LDPC decoding module, to facilitate effective decoding of the spatially coupled LDPC and reduce power consumption, at least one of the X CRC-coded sequences includes at least 2 sub-codeblock information sequences in the spatially coupled LDPC coding.

The CRC decoding module 930 is configured to obtain a corresponding to-be-encoded bit sequence from the first decoded sequence.

A corresponding to-be-encoded bit sequence can be obtained by performing CRC decoding on the first decoded sequence.

In an example, any one of the X CRC-coded sequences includes at least Y0 sub-codeblock information sequences used in the spatially coupled LDPC coding, where Y0 may equal 2, 4, 6, 8, 10, 12, 14, 16, 18, 20, or 24. In an example, the Y0 sub-codeblocks in the spatially coupled LDPC coding are Y0 consecutive sub-codeblock information sequences.

In an example, the number of bits in the CRC-coded sequence is determined by at least one of the following parameters: the length of a sub-codeblock information sequence of the spatially coupled LDPC coding; the number of systematic bits of a sub-codeblock of the spatially coupled LDPC coding; the number of sub-codeblocks of the spatially coupled LDPC coding; the length of the to-be-encoded bit sequence; the number of CRC parity bits; a transport block size; a period of a base graph matrix of the spatially coupled LDPC coding; a period of a base matrix of the spatially coupled LDPC coding; the maximum number of bits of an information sequence of the CRC encoding; the maximum number of bits of a CRC-coded sequence; or a code rate.

In an example, at least one of the X CRC-coded sequences has a number of bits equal to the sum of the lengths of Y sub-codeblock information sequences used in the spatially coupled LDPC coding, where Y is an integer greater than 1. In an example, X is an integer greater than 0.

In an example, the number of CRC-coded sequences is determined by at least one of the following parameters: the length of a sub-codeblock information sequence of the spatially coupled LDPC coding; the number of systematic bits of a sub-codeblock of the spatially coupled LDPC coding; the number of sub-codeblocks of the spatially coupled LDPC coding; the length of the to-be-encoded bit sequence; the number of CRC parity bits; a transport block size; a period of a base graph matrix of the spatially coupled LDPC coding; a period of a base matrix of the spatially coupled LDPC coding; the maximum number of bits of an information sequence of the CRC encoding; the maximum number of bits of a CRC-coded sequence; or a code rate.

In an example, the number of bits in a CRC-coded sequence equals the sum of the lengths of Y consecutive sub-codeblock information sequences used in the spatially coupled LDPC coding. In an example, Y is an integer greater than 1 and less than the number of sub-codeblocks of the spatially coupled LDPC coding. In an example, Y may equal 4, 6, 8, 10, 12, 16, 20, 24, 28, or 32.

In an example, X1 CRC-coded sequences exist among the X CRC-coded sequences, and the number of bits in each of the X1 CRC-coded sequences equals the sum of the lengths of Y1 sub-codeblock information sequences used in the spatially coupled LDPC coding. X2 CRC-coded sequences exist among the X CRC-coded sequences, and the number of bits in each of the X2 CRC-coded sequences equals the sum of the lengths of Y2 sub-codeblock information sequences used in the spatially coupled LDPC coding. X1 and X2 are both non-negative integers, and the sum of X1 and X2 equals X. Y1 and Y2 are both non-negative integers, and the sum of Y1 and Y2 equals L, where L is the number of sub-codeblocks of the spatially coupled LDPC coding. In an example, the difference between Y1 and Y2 is not greater than 1.

In at least one of the X CRC-coded sequences, all bits are placed in Y2 consecutive sub-codeblock information sequences in the spatially coupled LDPC coding, where Y2 is a positive integer multiple of T0, is a positive integer multiple of T1, or is a positive integer multiple of T0*T1. Here, T0 is the period of the base graph matrix of the spatially coupled LDPC coding, T1 is the period of the base matrix of the spatially coupled LDPC coding, and both T0 and T1 are positive integers.

The number of CRC parity bits in the CRC-coded sequence obtained by the CRC encoding may include at least one of the following: 6, 8, 11, 12, 14, 16, 18, 20, 24, or 32.

In an example, the maximum number of bits of the CRC-coded sequence may include at least one of the following: 4096, 6144, 8192, 8448, or 16384.

In an example, the length of a sub-codeblock information sequence of the spatially coupled LDPC coding may include at least one of the following: 128, 256, 400, 600, 512, 768, 800, 1024, 2048, or 4096.

For any method example of embodiment one, a corresponding receiving apparatus example may exist. Here, only the receiving apparatus example corresponding to example one in embodiment one is described, and the others are not repeated.

First, the receiving data module receives and acquires to-be-decoded data with a length of E=82944. The to-be-decoded data may be log-likelihood ratio information, where each piece of log-likelihood ratio information describes the reliability metric of a corresponding received bit. The to-be-decoded data includes data of L sub-codeblocks and data of a tail check sequence, where the length of each sub-codeblock equals N=1024, the length of the information sequence of each sub-codeblock equals K=512, and the length of the tail check sequence equals 1024.

Next, in the spatially coupled LDPC decoding module, spatially coupled LDPC decoding is performed on the to-be-decoded data to obtain decoded data. Decoding is performed on the data of the L sub-codeblocks in the to-be-decoded data according to the generator polynomial of CRC encoding, the base matrix of the spatially coupled LDPC coding, and the lifting size to obtain the decoded data. During the decoding process, if any CRC check of decoded output fails, the entire decoding is terminated. The decoded data corresponds to X CRC-coded sequences. In the spatially coupled LDPC decoding module, a sliding window decoding method is used to decode the to-be-decoded data, and the decoding window length is set to 8 (8 sub-codeblocks are updated simultaneously, and the first sub-codeblock is regarded as the target sub-codeblock).

During the sliding window decoding process, when Y sub-codeblock information sequences are output by hard decision, CRC check may be performed immediately. If the CRC check passes, it indicates that the information sequences of the current Y consecutive sub-codeblocks output by decoding have no errors, and the decoding window may continue to slide for decoding. If the CRC check fails, it indicates that errors exist in the information sequences of the current Y consecutive sub-codeblocks output by decoding, and the sliding window decoding may be stopped immediately, which can reduce decoding power consumption. In addition, since a decoding error has been detected in advance during decoding, the transmitting end may be quickly notified to retransmit the data of the current transport block, thereby reducing the reception latency. The CRC-coded sequence includes multiple sub-codeblock information sequences used in the spatially coupled LDPC coding, which makes the CRC check more efficient. If CRC encoding is performed on the information sequence of each sub-codeblock, the CRC overhead is very large. Moreover, when the sliding window decoding outputs the information sequence of each of Y consecutive sub-codeblocks, CRC check calculation may be performed simultaneously. When the last information sequence of the Y sub-codeblocks is output, the final check of a CRC-coded sequence is completed.

In this example, sliding window decoding is performed on the to-be-decoded data, and Y=16 sub-codeblocks are output sequentially. The combination of the information sequences of these Y=16 sub-codeblocks constitutes one CRC-coded sequence. CRC encoding check is performed using the generator polynomial. If the check passes, it indicates that the information sequences of these Y=16 sub-codeblocks have no errors, and the decoding window continues to slide for decoding. If the CRC check fails, the entire sliding window decoding is terminated, thus reducing unnecessary iteration update calculations. In addition, if the CRC check fails, the transmitting end may be immediately notified to retransmit the data. After the retransmitted data is received, sliding window decoding may start from the sub-codeblock position where the CRC check failed, without repeating decoding on the sub-codeblocks that have already been correctly decoded. This configuration can effectively reduce decoding power consumption and decoding reception latency.

In this example, the number B of bits in each CRC-coded sequence equals 8192. The 0-th CRC-coded sequence corresponds to information sequences of consecutive 0-th to 15-th sub-codeblocks. The 1-st CRC-coded sequence corresponds to information sequences of consecutive 16-th to 31-st sub-codeblocks. The 2-nd CRC-coded sequence corresponds to information sequences of consecutive 32-nd to 47-th sub-codeblocks. The 3-rd CRC-coded sequence corresponds to information sequences of consecutive 48-th to 63-rd sub-codeblocks. The 4-th CRC-coded sequence corresponds to information sequences of consecutive 64-th to 79-th sub-codeblocks. Therefore, assuming that the decoding window size of the sliding window decoding is 8 sub-codeblocks, when the data of the 0-th to 7-th sub-codeblocks in the to-be-decoded data is received, sliding window decoding may be started to output the information sequence of the 0-th sub-codeblock until the information sequence of the 15-th sub-codeblock is output. CRC check is then performed. The process continues sequentially until the check of the last CRC-coded sequence passes, at which point the decoding is correct.

The data transmission apparatus provided in this embodiment is configured to implement the data transmission method applied to the second communication device in the embodiment shown in FIG. 2. The data transmission apparatus provided in this embodiment has similar implementation principles and technical effects, which are not repeated herein.

In an embodiment, FIG. 10 is a diagram illustrating the structure of a communication device according to an embodiment of the present application. As shown in FIG. 10, the device provided in the present application includes a processor 1010, a memory 1020, and a communication module 1030. One or more processors 1010 may be included in the device. One processor 1010 is shown as an example in FIG. 10. One or more memories 1020 may be provided in the device. One memory 1020 is shown as an example in FIG. 10. The processor 1010, the memory 1020, and the communication module 1030 in the device may be connected via a bus or in other manners and may communicate with each other. FIG. 10 shows the connection via a bus as an example. In this embodiment, the device may be a first communication device or a second communication device.

The memory 1020, as a computer-readable storage medium, may be configured to store software programs, computer executable programs, and modules such as program instructions/modules (for example, the determination module 810, the CRC encoding module 820, the spatially coupled LDPC encoding module 830, and the transmission module 840 in the data transmission apparatus) corresponding to the device in any embodiment of the present application. The memory may also store some necessary parameters, data, and to-be-encoded bit sequences. The memory 1020 may include a program storage region and a data storage region. The program storage region may store an operating system and an application program required by at least one function. The data storage region may store data created according to the use of the device. Moreover, the memory 1020 may include a high-speed random-access memory and may also include a non-volatile memory such as at least one magnetic disk memory, a flash memory, or another non-volatile solid-state memory. In some examples, the memory 1020 may also include memories that are remotely disposed relative to the processor 1010, and these remote memories may be connected to the device via a network. Examples of the preceding network include but are not limited to, the Internet, an intranet, a local area network, a mobile communication network, and a combination thereof. The processor 1010 may perform encoding processing on the input to-be-encoded bit sequence. The communication module 1030 is used to implement the data interaction process between multiple communication devices. The communication module 1030 may include a single antenna or may include multiple antennas.

In a case where the communication device is a first communication device, the preceding device may be configured to execute the data transmission method applied to the first communication device in any one of the preceding embodiments and has corresponding functions and effects.

In the case where the communication device is a second communication device, the preceding device may be configured to execute the data transmission method applied to the second communication device in any one of the preceding embodiments and has corresponding functions and effects.

Embodiments of the present application also provide a storage medium containing computer-executable instructions. When the computer-executable instructions are executed by a computer processor, the instructions are used to execute a data transmission method applied to a first communication device. The method includes determining a to-be-encoded bit sequence; performing CRC encoding on the to-be-encoded bit sequence to obtain at least one CRC-coded sequence; performing spatially coupled LDPC encoding on the at least one CRC-coded sequence to obtain a coded bit sequence, where the at least one CRC-coded sequence includes at least two sub-codeblock information sequences used in spatially coupled LDPC coding; and transmitting at least a portion of bits in the coded bit sequence.

Embodiments of the present application also provide a storage medium containing computer-executable instructions. When the computer-executable instructions are executed by a computer processor, the instructions are used to execute a data transmission method applied to a second communication device. The method includes acquiring to-be-decoded data; performing spatially coupled LDPC decoding on the to-be-decoded data to obtain at least one first decoded sequence, where the at least one first decoded sequence corresponds to at least one CRC-coded sequence, and the at least one CRC-coded sequence includes at least two sub-codeblock information sequences used in spatially coupled LDPC coding; and obtaining a corresponding to-be-encoded bit sequence from the first decoded sequence.

It is to be understood by those skilled in the art that the term "user equipment" covers any suitable type of wireless user equipment, for example, a mobile phone, a portable data processing apparatus, a portable web browser, or a vehicle-mounted mobile station.

Generally speaking, various embodiments of the present application may be implemented in hardware or special-purpose circuits, software, logic, or any combination thereof. For example, some aspects may be implemented in hardware while other aspects may be implemented in firmware or software executable by a controller, a microprocessor, or another computing apparatus, though the present application is not limited thereto.

Embodiments of the present application may be implemented through the execution of computer program instructions by a data processor of a mobile apparatus, for example, implemented in a processor entity, by hardware, or by a combination of software and hardware. The computer program instructions may be assembly instructions, instruction set architecture (ISA) instructions, machine instructions, machine-related instructions, microcodes, firmware instructions, state setting data, or source or object codes written in any combination of one or more programming languages.

A block diagram of any logic flow among the drawings of the present application may represent program procedures, may represent interconnected logic circuits, modules, and functions, or may represent a combination of program procedures with logic circuits, modules, and functions. Computer programs may be stored in a memory. The memory may be of any type suitable for a local technical environment and may be implemented using any suitable data storage technology such as, but not limited to, a read-only memory (ROM), a random-access memory (RAM), or an optical memory device and system (a digital video disc (DVD), or a compact disc (CD)). The computer-readable medium may include a non-transitory storage medium. The data processor may be of any type suitable for a local technical environment, such as, but not limited to, a general-purpose computer, a special-purpose computer, a microprocessor, a digital signal processor (DSP), an application-specific integrated circuit (ASIC), a field-programmable gate array (FPGA), and a processor based on a multi-core processor architecture.

Embodiments of the present application also provide a computer program product, including a computer program. When the computer program is executed by a processor, the data transmission method provided in any embodiment of the present application can be implemented.

In the process of implementing the computer program product, computer program codes for performing the operations of the present application may be written in one or more programming languages or a combination of multiple programming languages. The programming languages include object-oriented programming languages such as Java, Smalltalk, and C++ and may also include conventional procedural programming languages such as "C" or similar programming languages. The program codes may be executed entirely on a user computer, partly on a user computer, as a stand-alone software package, partly on a user computer and partly on a remote computer, or entirely on a remote computer or a server. In a case related to the remote computer, the remote computer may be connected to the user computer via any type of network including a local area network (LAN) or a wide area network (WAN) or may be connected to an external computer (for example, via the Internet by an Internet service provider).

## Claims

1. A data transmission method, the method being applied to a first communication device and comprising:
determining a to-be-encoded bit sequence;
performing cyclic redundancy check, CRC, encoding on the to-be-encoded bit sequence to obtain at least one CRC-coded sequence;
performing spatially coupled low-density parity-check, LDPC, encoding on the at least one CRC-coded sequence to obtain a coded bit sequence, wherein the at least one CRC-coded sequence comprises at least two sub-codeblock information sequences used in spatially coupled LDPC coding; and
transmitting at least a portion of bits in the coded bit sequence.

2. The data transmission method according to claim 1, wherein the at least one CRC-coded sequence comprises a first preset number of sub-codeblock information sequences used in the spatially coupled LDPC coding;
wherein the first preset number is an even number greater than 0.

3. The data transmission method according to claim 1, wherein the at least one CRC-coded sequence comprises at least two sub-codeblock information sequences used in the spatially coupled LDPC coding, wherein the at least two sub-codeblock information sequences are consecutive sub-codeblock information sequences in the spatially coupled LDPC coding.

4. The data transmission method according to claim 1, wherein the at least one CRC-coded sequence comprises a second preset number of sub-codeblock information sequences used in the spatially coupled LDPC coding;
wherein the second preset number is a positive integer multiple of a period of a base graph matrix of the spatially coupled LDPC coding, or is a positive integer multiple of a period of a base matrix of the spatially coupled LDPC coding, or is a positive integer multiple of a product of a period of a base graph matrix of the spatially coupled LDPC coding and a period of a base matrix of the spatially coupled LDPC coding.

5. The data transmission method according to claim 1, wherein a number of bits comprised in a CRC-coded sequence is determined by at least one of following parameters: a length of a sub-codeblock information sequence of the spatially coupled LDPC coding; a number of systematic bits of a sub-codeblock of the spatially coupled LDPC coding; a number of sub-codeblocks of the spatially coupled LDPC coding; a length of the to-be-encoded bit sequence; a number of CRC parity bits; a transport block size; a period of a base graph matrix of the spatially coupled LDPC coding; a period of a base matrix of the spatially coupled LDPC coding; a maximum number of bits of an information sequence of the CRC encoding; a maximum number of bits of a CRC-coded sequence; or a code rate.

6. The data transmission method according to claim 1, wherein a number of bits comprised in the at least one CRC-coded sequence is equal to a sum of lengths of a third preset number of sub-codeblock information sequences used in the spatially coupled LDPC coding;
wherein the third preset number is an integer greater than 1 and less than or equal to a number of sub-codeblocks of the spatially coupled LDPC coding.

7. The data transmission method according to claim 1, wherein a number of CRC-coded sequences is determined by at least one of following parameters: a length of a sub-codeblock information sequence of the spatially coupled LDPC coding; a number of systematic bits of a sub-codeblock of the spatially coupled LDPC coding; a number of sub-codeblocks of the spatially coupled LDPC coding; a length of the to-be-encoded bit sequence; a number of CRC parity bits; a transport block size; a period of a base graph matrix of the spatially coupled LDPC coding; a period of a base matrix of the spatially coupled LDPC coding; a maximum number of bits of an information sequence of the CRC encoding; a maximum number of bits of a CRC-coded sequence; or a code rate.

8. The data transmission method according to claim 1, wherein in the CRC encoding, at least two CRC-coded sequences are obtained, and numbers of sub-codeblock information sequences comprised in every two CRC-coded sequences among the at least two CRC-coded sequences are equal to each other.

9. The data transmission method according to claim 1, wherein in the CRC encoding, at least two CRC-coded sequences are obtained, a first value is a maximum value of numbers of sub-codeblock information sequences comprised in the at least two CRC-coded sequences, and a second value is a minimum value of numbers of sub-codeblock information sequences comprised in the at least two CRC-coded sequences, and a maximum difference between the first value and the second value is equal to 1.

10. The data transmission method according to claim 1, wherein in the CRC encoding, a fourth preset number of CRC-coded sequences are obtained, wherein numbers of sub-codeblock information sequences comprised in a fifth preset number of CRC-coded sequences are equal, the fourth preset number is an integer greater than 1, and the fifth preset number is obtained by subtracting one from the fourth preset number.

11. The data transmission method according to claim 1, wherein a number of sub-codeblocks of the spatially coupled LDPC coding is an integer greater than 1.

12. The data transmission method according to claim 1, wherein a maximum number of bits of a CRC-coded sequence of the at least one CRC-coded sequence comprises at least one of the following: 4096, 6144, 8192, 8448, or 16384.

13. The data transmission method according to claim 1, wherein a length of a sub-codeblock information sequence of the spatially coupled LDPC coding is an integer greater than or equal to 128 and less than or equal to 8448.

14. The data transmission method according to claim 1, wherein a number of CRC-coded sequences is at least equal to 2.

15. The data transmission method according to claim 1, wherein a number of CRC parity bits in a CRC-coded sequence of the at least one CRC-coded sequence comprises one of the following: 6, 8, 11, 12, 14, 16, 18, 20, 24, or 32.

16. The data transmission method according to claim 1, wherein a number of sub-codeblock information sequences comprised in a CRC-coded sequence of the at least one CRC-coded sequence comprises one of the following: 2, 4, 6, 8, 10, 12, 14, 16, 18, 20, or 24.

17. A data transmission method, the method being applied to a second communication device and comprising:
acquiring to-be-decoded data;
performing spatially coupled low-density parity-check, LDPC, decoding on the to-be-decoded data to obtain at least one first decoded sequence; wherein the at least one first decoded sequence corresponds to at least one cyclic redundancy check, CRC, encoded sequence, and the at least one CRC-coded sequence comprises at least two sub-codeblock information sequences used in spatially coupled LDPC coding; and
obtaining a corresponding to-be-encoded bit sequence from the first decoded sequence.

18. A communication device, comprising: a memory and at least one processor; wherein
the memory is configured to store at least one program; and
the at least one program, when executed by the at least one processor, causes the at least one processor to implement the data transmission method according to any one of claims 1 to 16 or 17.

19. A storage medium storing a computer program that, when executed by a processor, the data transmission method according to any one of claims 1 to 16 or 17 is implemented.
